(19) Europäisches Patentamt

European Patent Office

Office européen des brevets

(11) **EP 1 349 217 A1**

(12) **EUROPEAN PATENT APPLICATION**
published in accordance with Art. 158(3) EPC

(43) Date of publication:
**01.10.2003 Bulletin 2003/40**

(51) Int Cl.[7]: **H01L 33/00**, H01L 21/365

(21) Application number: **01998176.0**

(22) Date of filing: **28.11.2001**

(86) International application number:
**PCT/JP01/10361**

(87) International publication number:
**WO 02/045179 (06.06.2002 Gazette 2002/23)**

(84) Designated Contracting States:
**AT BE CH CY DE DK ES FI FR GB GR IE IT LI LU MC NL PT SE TR**

(30) Priority: **30.11.2000 JP 2000366118**

(71) Applicant: **Shin-Etsu Handotai Co., Ltd Tokyo 100-0005 (JP)**

(72) Inventors:
• **ISHIZAKI, Jun-ya,
c/o SHIN-ETSU HANDOTAI CO.LTD.
Annaka-shi, Gunma (JP)**

• **YAMADA, Masato,
SHIN-ETSU HANDOTAI CO. LTD.
Annaka-shi, Gunma (JP)**

(74) Representative:
**TER MEER STEINMEISTER & PARTNER GbR
Patentanwälte,
Mauerkircherstrasse 45
81679 München (DE)**

(54) **LIGHT-EMITTING DEVICE AND ITS MANUFACTURING METHOD AND VISIBLE-LIGHT-EMITTING DEVICE**

(57)     A light emitting device 1 has a light emitting layer portion in which a p-type cladding layer 2, an active layer 33 and an n-type cladding layer 34 are stacked in this order, and the p-type cladding layer 2 is composed of a p-type $Mg_xZn_{1-x}O$ (where, $0<x\leqq1$) layer. By forming these layers by the MOVPE process, oxygen deficiency during the film formation is effectively prevented from occurring, and a p-type $Mg_xZn_{1-x}O$ layer having desirable characteristics can be obtained.

*Fig.1*

PROTECTIVE LAYER — 35
OXYGEN-ION-PACKED PLANE
p-MgZnO (p-TYPE CLADDING LAYER) — 2
METAL-ION-PACKED PLANE
ACTIVE LAYER — 33
n-TYPE CLADDING LAYER — 34

EP 1 349 217 A1

## Description

TECHNICAL FIELD

This invention relates to a semiconductor-base, light emitting device, in particular to a light emitting device suitable for blue light emission or ultraviolet emission, a method of fabricating the same, and a visible-light emitting apparatus using an ultraviolet emitting device.

BACKGROUND ART

There have long been demands for high-luminance, light emitting device capable of causing short-wavelength emission in the blue light region. Such light emitting device has recently realized by using AlGaInN-base materials. Rapid progress has also been made in applying the device to full-color, light emitting apparatuses or to display apparatuses by combining it with red and green high-luminance, light emitting devices.

Use of the AlGaInN-base material, however, inevitably raises the costs because the material contains Ga and In as major components, both of which are relatively rare metals. Another one of major problems of the material is that the growth temperature thereof is as high as 700 to 1,000°C, and thus consumes a considerably large amount of energy for the production. This is undesirable not only in terms of cost reduction, but also in terms of being against the stream of the times where discussions on energy saving and suppression of global warming are prevailing.

Therefore a subject of the invention is to provide a light emitting device wherein a light emitting layer portion thereof is obtainable using a less amount of rare metals, can be grown at relatively low temperature, and ensuring high-luminance light emission in the blue light region or further in the ultraviolet region, a method of fabricating such device, and a visible-light emitting apparatus using semiconductor ultraviolet emitting devices.

DISCLOSURE OF THE INVENTION

As a solution for the aforementioned problem, a light emitting device of the invention has a light emitting layer portion in which an n-type cladding layer, an active layer and a p-type cladding layer are stacked in this order, and the p-type cladding layer is composed of a p-type $Mg_xZn_{1-x}O$ (where, $0<x\leqq1$) layer.

A method of fabricating a light emitting device of the invention is to fabricate the aforementioned light emitting device, wherein the p-type $Mg_xZn_{1-x}O$ layer is formed by the metal organic vapor-phase epitaxy process.

As for light emitting material used for blue-light or ultraviolet emission, ZnO has been known as a possible candidate alternative to AlGaInN. ZnO-base oxide semiconductor material, however, tends to cause oxygen deficiency and thus intrinsically tends to have an n-type conductivity, so that it has generally been assumed as being difficult to make this material have a p-type conductivity which is indispensable for composing a light emitting device. If a p-type ZnO should be obtained anyhow, it is impossible to achieve a sufficient barrier height against the p-type carrier at the interface with the active layer since the upper energy level of the valence band in ZnO is relatively high, and this may lower the emission efficiency.

Thus in the invention, a composite oxide in which a part of Zn in ZnO is substituted with Mg, and is expressed as $Mg_xZn_{1-x}O$ ($0<x\leqq1$: the composite oxide may occasionally be abbreviated as MgZnO, hereinafter, but this never means Mg:Zn:O=1:1:1) is used as a constituent of the p-type cladding layer. In MgZnO, the band gap energy $E_g$ of the oxide expands since the upper energy level $E_v$ of the valence band is lowered by the containment of Mg. This increases the barrier height against the p-type carrier at the interface with the active layer, and raises the emission efficiency.

To ensure the above-described effect, oxygen-deficiency concentration in the p-type $Mg_xZn_{1-x}O$ layer is preferably reduced to as low as $10/cm^3$ or below. It is therefore effective to adopt the metal organic vapor-phase epitaxy process as a vapor-phase growth process for forming the p-type $Mg_xZn_{1-x}O$ layer. Other vapor-phase growth processes such as RF sputtering and molecular beam epitaxy (MBE) are proceeded under a pressure of the growth atmosphere of as low as $1.33\times10^{-2}$ to 1.33 Pa ($10^{-4}$ to $10^{-2}$ Torr), so that it is very difficult to prevent the oxygen deficiency from generating, and is thus practically impossible to form the p-type $Mg_xZn_{1-x}O$ layer. On the contrary, in the vapor-phase growth based on the MOVPE process, oxygen partial pressure during the growth can arbitrarily be changed, so that the oxygen disorption and consequent oxygen deficiency can effectively be prevented from occurring by raising the atmospheric pressure to a certain extent. As a consequence, the p-type $Mg_xZn_{1-x}O$ layer, in particular the p-type $Mg_xZn_{1-x}O$ layer having an oxygen deficiency concentration of $10/cm^3$ or below, which could not be attained in the conventional process, can be realized. The lower the oxygen deficiency concentration, the better (that is, not precluded from becoming $0/cm^3$).

Japanese Laid-Open Patent Publication No. 11-168262 discloses a two-dimensional-array planar light emitting apparatus using a light emitting layer portion composed of the AlGaInN-base material, or composed of oxides of Zn and Mg, or alloy thereof. This publication discloses not only an embodiment in which the light emitting layer portion is used as a visible light emitting source, but also a full-color display in which the light emitting layer portion is composed as a ultraviolet emitting source so as to allow the fluorescent material layers of the individual colors to be excited for light emission by the ultraviolet radiation. Japanese Laid-Open Patent Publication No. 11-168262, however, only describes that the light emitting layer portion composed of oxides of Zn and Mg, or alloy thereof is epitaxially grown on a substrate, and no description is made on any constitution of the light emitting layer portion including the p-type $Mg_xZn_{1-x}O$ layer, and any specific method of forming the p-type $Mg_xZn_{1-x}O$ layer.

By carrying out formation of the p-type $Mg_xZn_{1-x}O$ layer based on the MOVPE process in an atmosphere conditioned at a pressure of $1.33 \times 10^3$ Pa (10 Torr) or above, oxygen deficiency during the film formation can more effectively be prevented from occurring, and the p-type $Mg_xZn_{1-x}O$ layer having excellent characteristics can be obtained. In this case, it is more preferable to set the oxygen partial pressure (assuming that any oxygen-containing molecules other than $O_2$ are to be included after converting the contained oxygen into $O_2$) to $1.33 \times 10^3$ Pa (10 Torr) or above.

By using such p-type $Mg_xZn_{1-x}O$ layer as the p-type cladding layer, a light emitting device capable of high-luminance light emission in the blue light region or in the ultraviolet region can readily be fabricated. Because the p-type cladding layer does not contain rare metals such as Ga and In as major components, the amount of use of such rare metals in the light emitting layer portion as a whole can be reduced, and the light emitting device can thus be fabricated at low costs. Since the $Mg_xZn_{1-x}O$ layer can be grown in the vapor phase at relatively low temperatures, the process is also effective in terms of energy saving.

To make the $Mg_xZn_{1-x}O$ layer as p-type, it is necessary to add an appropriate p-type dopant. As the p-type dopant, any one or more selected from the group consisting of N, Ga, Al, In, Li, Si, C and Se can be used. Among these, use of in particular N is effective in terms of obtaining desirable p-type characteristics. It is also effective to use, as a metal dopant, one or more selected from the group consisting of Ga, Al, In and Li, and particularly Ga. Use of these metals together with N can further ensure achievement of the desirable p-type characteristics. Even when Ga or In is used, no problem in cost increase or so will arise since the amount of use thereof is extremely small.

To ensure a sufficient level of emission characteristics, p-type carrier concentration of the p-type $Mg_xZn_{1-x}O$ layer is preferably adjusted to $1 \times 10^{16}/cm^3$ to $8 \times 10^{18}/cm^3$. The p-type carrier concentration less than $1 \times 10^{16}/cm^3$ may make it difficult to obtain a sufficient emission luminance. On the other hand, the p-type carrier concentration exceeding $8 \times 10^{18}/cm^3$ makes the amount of p-type carrier to be injected into the active layer excessive, and consequently increases p-type carriers which does not contribute for light emission by diffusing back to the p-type $Mg_xZn_{1-x}O$ layer or by entering the n-type cladding layer coming over the potential barrier, to thereby degrade the emission efficiency.

Next, a visible-light emitting apparatus of the invention has a light emitting device of the invention composed as a semiconductor ultraviolet emitting device, that is, a semiconductor ultraviolet emitting device having a light-emitting layer portion in which an n-type cladding layer, an active layer and a p-type cladding layer are stacked in this order and the p-type cladding layer is composed of a p-type $Mg_xZn_{1-x}O$ (where, $0<x\leq1$) layer, and a fluorescent material which emits visible light as being irradiated by ultraviolet radiation from the semiconductor ultraviolet emitting device.

Conventionally, fluorescent lamps are widely used as the visible-light emitting apparatus. Fluorescent lamps, however, suffer from the drawbacks below:

• the service life comes to the end within a relatively early stage since ultraviolet radiation is generated based on cathode discharge;
• high voltage and large power consumption necessary;
• additional peripheral circuit such as stabilizer and starter necessary; and
• the lamps will be more repelled in the future from the viewpoint of environmental preservation since disposal of them will release mercury which has been enclosed as a ultraviolet emission source in the glass tubes.

On the contrary, the visible-light emitting apparatus of the invention shows only a small time-dependent degradation and consequently has a long service life since the semiconductor light emitting device is used as a ultraviolet emission source, and can simplify the circuit constitution since the apparatus is capable of continuous light emission if only provided basically with a current supply circuit therefor. Moreover, the apparatus does not need high voltage, and thus causes only a small power consumption by virtue of its small resistance loss. The light emitting apparatus can be realized in an ecologically clean manner since it does not use any substances such as mercury undesirable from the viewpoint of environmental preservation. Use of the light emitting device of the invention as a ultraviolet emitting device is advantageous in cost saving, and further energy saving can be achieved by virtue of its high ultraviolet emission efficiency.

BRIEF DESCRIPTION OF THE DRAWINGS

Fig. 1 is a conceptual drawing of the light emitting device of the invention;
Fig. 2 is a schematic drawing of a crystal structure of MgZnO;
Fig. 3 is a schematic drawing of an arrangement of the metal ions and oxygen ions of the MgZnO layer;
Fig: 4 is a schematic drawing of a status in which oxygen disorption possibly occurs during formation of the MgZnO layer is suppressed by the atmospheric pressure;

Fig. 5A is a schematic diagram of the MgZnO layer formed as a single crystal layer;

Fig. 5B is a schematic drawing of the MgZnO layer formed as a c-axis-oriented polycrystal layer;

Fig. 6 is a schematic sectional view showing a first embodiment of the light emitting device according to the invention;

Fig. 7 is a schematic sectional view showing a second embodiment of the light emitting device according to the invention;

Fig. 8A is a schematic band chart of a light emitting device using a junction structure of type-I and type-II band lineups;

Fig. 8B is a schematic band chart of another light emitting device using a junction structure of type-I and type-II band lineups;

Fig. 9A is an explanatory drawing of an exemplary process step for fabricating the light emitting device shown in Fig. 6;

Fig. 9B is a process drawing as continued from Fig. 9A;

Fig. 9C is a process drawing as continued from Fig. 9B;

Fig. 9D is a process drawing as continued from Fig. 9C;

Fig. 10A is an explanatory drawing of an exemplary process step for fabricating the light emitting device shown in Fig. 11;

Fig. 10B is a process drawing as continued from Fig. 10A;

Fig. 10C is a process drawing as continued from Fig. 10B;

Fig. 10D is a process drawing as continued from Fig. 10C;

Fig. 11 is a schematic sectional view showing a third embodiment of the light emitting device according to the invention;

Fig. 12 is a schematic sectional view showing a first modified example of the light emitting device shown in Fig. 11;

Fig. 13 is a schematic sectional view showing a second modified example of the light emitting device shown in Fig. 11;

Fig. 14 is a schematic sectional view showing a fourth embodiment of the light emitting device according to the invention;

Fig. 15 is a schematic sectional view similarly showing a fifth embodiment of the light emitting device;

Fig. 16 is a schematic sectional view similarly showing a sixth embodiment of the light emitting device;

Fig. 17 is a schematic band chart of a light emitting device using a junction structure of type-I band lineup;

Fig. 18A is an explanatory drawing of an exemplary process step for fabricating the light emitting device shown in Fig. 16;

Fig. 18B is a process drawing as continued from Fig. 18A;

Fig. 18C is a process drawing as continued from Fig. 18B;

Fig. 18D is a process drawing as continued from Fig. 18C;

Fig. 19A is an explanatory process drawing of an exemplary method of fabricating the light emitting device of the invention based on the bonding system;

Fig. 19B is a process drawing as continued from Fig. 19A;

Fig. 20A is a drawing for explaining operation of the light emitting device of the invention;

Fig. 20B is another drawing for explaining operation of the light emitting device of the invention;

Fig. 21 is a drawing for explaining principle of the visible-light emitting apparatus of the invention;

Fig. 22 is a schematic sectional view showing a first example of the visible-light emitting apparatus composed as a lighting apparatus;

Fig. 23 is a schematic sectional view similarly showing a second example;

Fig. 24 is a schematic sectional view similarly showing a third example;

Fig. 25 is a schematic sectional view similarly showing a fourth example;

Fig. 26A is a drawing for explaining a principle of a display apparatus using the visible-light emitting apparatus of the invention;

Fig. 26B is a drawing for explaining the principle as continued from Fig. 26A;

Fig. 27 is a schematic sectional view showing a seventh embodiment of the light emitting device according to the invention;

Fig. 28A is an explanatory drawing of an exemplary process step for fabricating the light emitting device shown in Fig. 27;

Fig. 28B is a process drawing as continued from Fig. 28A;

Fig. 29 is a schematic sectional view showing a second example of the visible-light emitting apparatus composed as a lighting apparatus;

Fig. 30 is a schematic sectional view showing a third example of the visible-light emitting apparatus composed as a lighting apparatus;

Fig. 31 is a schematic sectional view showing a first example of the visible-light emitting apparatus composed as a display apparatus; and

Fig. 32 is a schematic drawing showing an exemplary apparatus for forming the MgZnO layer based on the MOVPE process.

BEST MODE FOR CARRYING OUT THE INVENTION

Embodiments of the invention will be explained referring to the drawings.

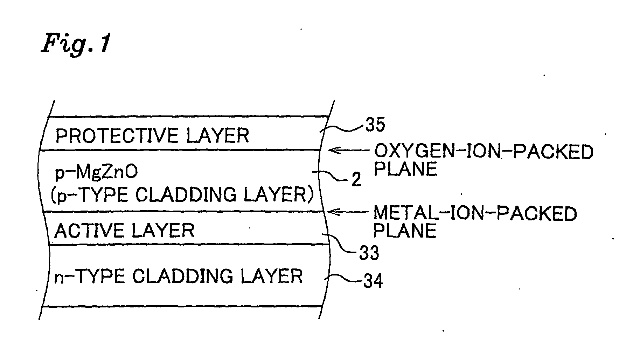

Fig. 1 is a drawing schematically showing a stacked structure of the essential portion of the light emitting device of the invention, and the device has a light emitting layer portion in which an n-type cladding layer 34, an active layer 33 and a p-type cladding layer 2 are stacked in this order. The p-type cladding layer 2 is composed as a p-type $Mg_xZn_{1-x}O$ layer ($0<x\leqq1$: may occasionally be abbreviated as p-type MgZnO layer 2, hereinafter). In the p-type MgZnO layer 2, a trace amount of for example one or more selected from the group consisting of N, Ga, Al, In and Li are contained as the p-type dopant. The p-type carrier concentration is adjusted within a range from $1\times10^{16}$/cm$^3$ to $8\times10^{18}$/cm$^3$ as described in the above, and more specifically within a range from $10^{17}$/cm$^3$ to $10^{18}$/cm$^3$ or around.

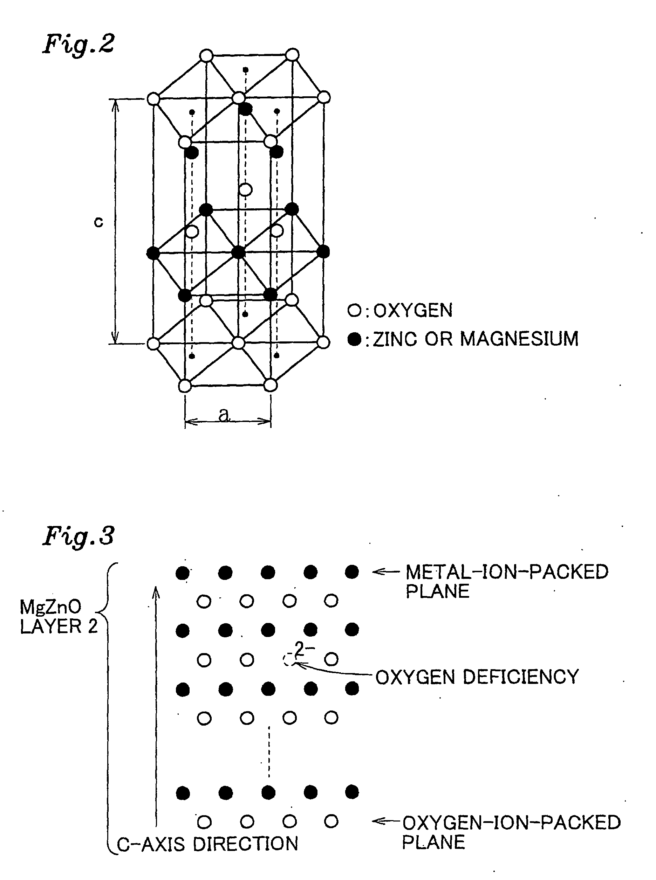

Fig. 2 is a schematic drawing of a crystal structure of MgZnO, where so-called wurtzite structure is shown. In this structure, oxygen-ion-packed planes and metal-ion- (Zn ion or Mg ion) packed planes are stacked along the direction of the c-axis, and as shown in Fig. 3, the p-type MgZnO layer 2 is formed so as to align the c-axis thereof along the thickness-wise direction. Formation of a vacancy due to disorption of an oxygen ion causes oxygen deficiency, and consequently produces an electron as an n-type carrier. Too much formation of such oxygen deficiency undesirably increases the n-type carriers, to thereby ruin p-type conductivity. It is therefore important that how to suppress generation of the oxygen deficiency in order to form the p-type MgZnO layer.

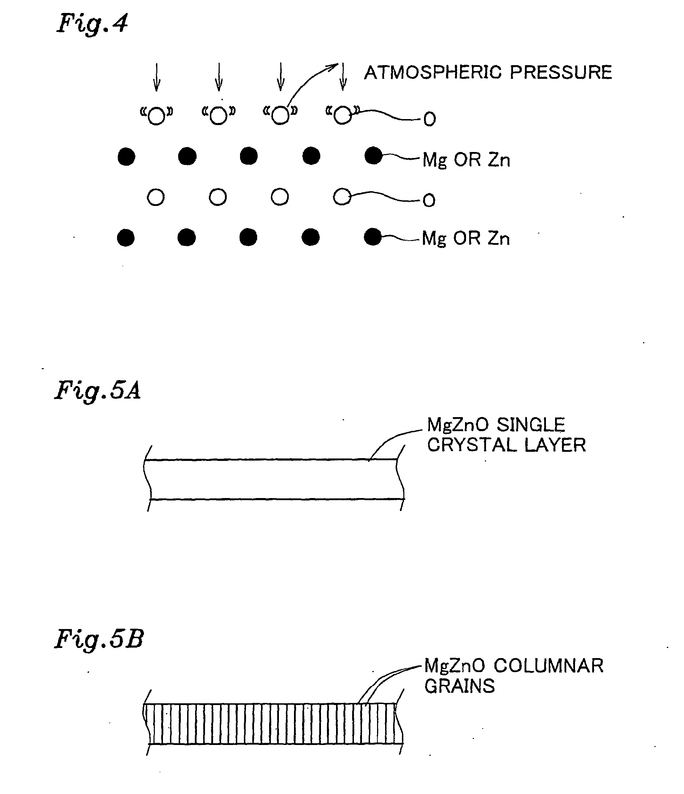

As has been described in the above, the p-type MgZnO layer 2 is formed by the MOVPE process. Principle of the MOVPE process *per se* is publicly known. The above-described addition of the p-type dopant is executed during the MOVPE process. By carrying out the MOVPE process in an atmosphere conditioned at a pressure of $1.33\times10^3$ Pa (10 Torr) or above, the disorption of oxygen is suppressed as shown in Fig. 4, and a desirable p-type MgZnO layer 2 having a less degree of oxygen deficiency can be obtained.

Although the p-type MgZnO layer 2 is ideally formed by epitaxial growth as a single crystal layer as shown in Fig. 5A, a relatively desirable emission efficiency can be obtained even if it is formed as a polycrystal layer as shown in Fig. 5B provided that the c-axis is oriented along the thickness-wise direction. It is said that MgZnO is desirable since such structure can be obtained in a relatively easy manner by giving thermal gradient in the thickness-wise direction of the substrate on which the layer is grown.

Now referring back to Fig. 1, the active layer 33 is composed of a material having an appropriate band gap depending on desired emission wavelength. For example, for those available for visible light emission, materials having band gap energies $E_g$ (3.10 to 2.18 eV or around), capable of causing light emission in a wavelength range of 400 to 570 nm, are selected. Although this range covers emission wavelength from violet region to green region, those having band gap energies $E_g$ (2.76 to 2.48 eV or around) capable of causing light emission in a wavelength range of 450 to 500 nm are selected in particular for the case where blue light emission is desired. On the other hand, those having band gap energies $E_g$ (4.43 to 3.10 eV or around) capable of causing light emission in a wavelength range of 280 to 400 nm are selected in particular for the case where ultraviolet emission is desired.

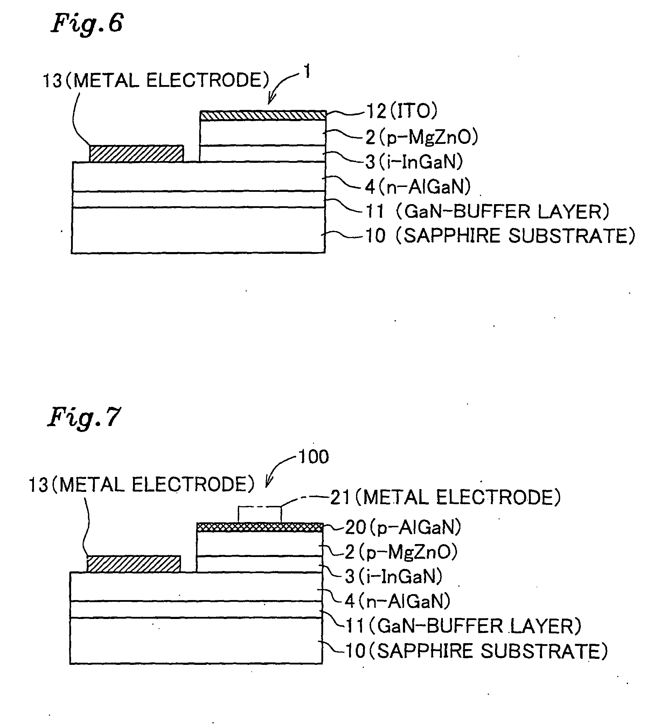

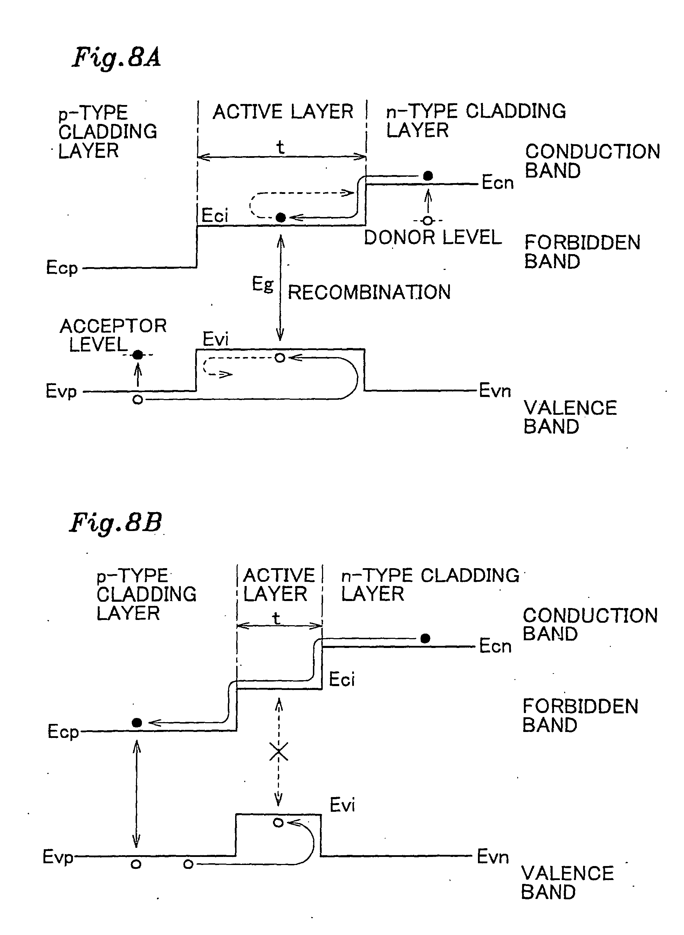

The active layer 33 can be formed typically using a semiconductor capable of forming a type-II band lineup between itself and the p-type $Mg_xZn_{1-x}O$ layer. An example of such active layer is an InGaN layer (referred to as InGaN active layer, hereinafter) 3 as shown in the light emitting device 1 in Fig. 6, or in the light emitting device 100 in Fig. 7. It is to be noted now that "a type-II band lineup is formed between the active layer and the p-type $Mg_xZn_{1-x}O$ layer" indicates a junction structure, as shown in Figs. 8A and 8B, in which the individual energy levels of the bottom of the conduction band and the upper end of the valence band $E_{cp}$, $E_{vp}$ of the p-type cladding layer (p-type $Mg_xZn_{1-x}O$ layer 2), and the individual energy levels of the bottom of the conduction band and the upper end of the valance band $E_{ci}$, $E_{vi}$ of the active layer satisfy the following relations of inequality:

$$E_{ci} > E_{cp} \qquad (1)$$

$$E_{vi} > E_{vp} \qquad (2)$$

In this structure, no specific barrier will appear for the forward diffusion of electrons (n-type carriers) from the active layer to the p-type cladding layer, but a relatively high potential barrier is formed for the reverse diffusion of holes (p-type carriers) from the active layer to the p-type cladding layer. This promotes carrier recombination in the active layer, and can achieve a high emission efficiency. Assuming now that the layer is expressed as $In_\alpha Ga_{1-\alpha}N$, where $\alpha$ is an InN alloy composition, a relation of $0.34\leqq\alpha\leqq0.47$ is preferable for blue visible light emission, and a relation of $0\leqq\alpha\leqq0.19$ is preferable for ultraviolet emission.

In this case, the n-type cladding layer preferably uses a semiconductor capable of forming a type-I band lineup between itself and the active layer. An example of such active layer is an n-type AlGaN ($In_\beta Ga_{1-\beta}N$) layer 4 as shown in the light emitting device 1 in Fig. 6, or in the light emitting device 100 in Fig. 7. It is to be noted now that "a type-I band lineup is formed between the n-type cladding layer and the active layer" indicates a junction structure, as shown in Figs. 8A and 8B, in which the individual energy levels of the bottom of the conduction band and the upper end of the valence band $E_{ci}$, $E_{vi}$ of the active layer, and the individual energy levels of the bottom of the conduction band and the upper end of the valance band $E_{cn}$, $E_{vn}$ of the n-type cladding layer (n-type AlGaN layer 4) satisfy the following relations of inequality:

$$E_{ci} < E_{cn} \qquad (3)$$

$$E_{vi} > E_{vn} \qquad (4)$$

In this structure, a relatively high potential barrier is formed for the reverse diffusion of electrons from the n-type cladding layer to the active layer, and a quantum well is formed at the upper end of the valence band corresponding to the position of the active layer, to thereby enhance the confinement efficiency of holes. All of these promote carrier recombination in the active layer, and consequently achieve a high emission efficiency.

In the structures shown in Figs. 8A and 8B, a suppressive effect of reverse diffusion of holes from the active layer to the p-type cladding layer can successfully be raised by increasing the energy barrier height ($E_{vi}$ - $E_{vp}$) at the upper end of the valence band. For this purpose, it is effective to raise MgO alloy composition of the p-type $Mg_xZn_{1-x}O$ layer 2 (that is, value of "x") composing the p-type cladding layer. The alloy composition "x" is determined depending on desired current density, so as not to cause excessive leakage of the carriers towards the p-type cladding layer. In a typical case where the active layer is composed of the InGaN layer 3, the alloy composition "x" is preferably set within a range from 0.05 to 0.2 or around for light emitting diode, and 0.1 to 0.4 or around for semiconductor laser light source.

The bottom of the conduction band descends in a step-wise manner from the active layer towards the p-type cladding layer, and the electrons not contributed to the emissive recombination in the active layer then flow into the p-type cladding layer having a higher carrier concentration, and become no more contributable to light emission due to Auger recombination or the like. In order to raise the emission efficiency, it is therefore necessary that electrons as much as possible recombine with holes before they flow into the p-type cladding layer, and it is therefore effective to increase the thickness "t" of the active layer to a certain level or above (e.g., 30 nm or above). As shown in Fig. 8B, too small thickness "t" of the active layer increases electrons possibly flow into the p-type cladding layer and become not contributable to the light emission, and this results in lowered emission efficiency. On the other hand, increase in the thickness "t" of the active layer beyond a necessary level results in lowered carrier density in the active layer and thus ruins the emission efficiency. The thickness is thus typically set to 2 $\mu$m or below.

In Figs. 8A and 8B, it is advantageous in view of suppressing non-emissive recombination at the junction boundary that a relation of $E_{cp} > E_{vi}$ is satisfied similarly for the case where the InGaN active layer is used, that is, the p-type cladding layer and the active layer have forbidden bands which overlap with each other.

Next, as shown in Fig. 1, the surface of the p-type $Mg_xZn_{1-x}O$ layer 2 opposite to that in contact with the active layer (InGaN layer) 3 can be covered with a protective layer 35 which is composed of a conductive material or a semiconductor material. Because MgZnO tends to degrade properties thereof through reaction with moisture to produce hydroxide by nature, provision of the protective layer 35 for the p-type $Mg_xZn_{1-x}O$ layer 2 is fairly effective in view of preventing such nonconformity.

The p-type $Mg_xZn_{1-x}O$ layer, as shown in Fig. 3, has a structure in which a c-axis is oriented along the thickness-wise direction, that is, a structure in which oxygen-ion-packed layers, and metal-ion-packed layers are alternately stacked in the thickness-wise direction. Taking now electrically neutral conditions into account, the layer having a metal-ion-packed layer exposed in one surface (referred to as "metal-ion-packed plane", hereinafter) should unconditionally have an oxygen-ion-packed layer exposed in the other surface (referred to as "oxygen-ion-packed plane", hereinafter). The side more likely to undergo a reaction caused by moisture adhesion is the exposure side of the latter oxygen-ion-packed plane.

For example, if the metal-ion-packed plane is oriented so as to contact with the active layer 33 as shown in Fig. 1, the oxygen-ion-packed plane unconditionally exposes on the opposite side, and it is effective to cover it with the protective layer 35. In this case, the protective layer 35 is formed so as to contact with the oxygen-ion-packed plane of the p-type $Mg_xZn_{1-x}O$ layer 2. On the contrary, if the oxygen-ion-packed plane is oriented so as to contact with the active layer 33, the metal-ion-packed plane less labile to the reaction with moisture exposes on the opposite side. While the protective layer 35 is omissible in this case, coverage with the protective layer 35 can provide the device structure more excellent in the weatherability.

In the light emitting device 1 shown in Fig. 6, a transparent conductive material layer 12 is used as the protective layer. Use of the transparent conductive material 12, that is, the protective layer composed of a transparent material, successfully contributes to improvement in the light extraction efficiency for the case where the p-type $Mg_xZn_{1-x}O$ layer 2 side is defined as the light extraction plane. In this case, the transparent conductive material layer 12 can be used also as an electrode for supplying current for light emission. Unlike the case in which a metal electrode is disposed, such constitution allows the electrode *per se* to pass the light therethrough, and makes it no more necessary to intentionally form a non-electrode-forming area for light extraction around the electrode, so that the electrode can be formed in a larger area without lowering the light extraction efficiency. It is also advantageous in simplifying the device because there will be no need to form a current spreading layer.

As specific materials for composing the transparent conductive material layer 12, $In_2O_3$:Sn (tin-doped indium oxide: generally known as ITO) and $SnO_2$:Sb (antimony-doped tin oxide: generally known as Nesa) are preferably used. ITO is excellent in the conductivity, and can contribute also to reduction in the device drive voltage. On the other hand, Nesa is slightly inferior to ITO in conductivity but is advantageous for its inexpensiveness. Nesa is also higher in heat resistance, and thus it is effective for the case where high-temperature process is necessary after forming the transparent conductive material. ITO film can be formed by sputtering or vacuum evaporation, and Nesa film can be formed by the CVD process. It is also allowable to form these transparent conductive material layers 12 by the sol-gel process.

The light emitting device 1 shown in Fig. 6 more specifically has the following structure. That is, on a sapphire (single crystal alumina) substrate 10, a buffer layer 11 composed of GaN is formed, and further thereon an n-type AlGaN layer 4 as an n-type cladding layer, an InGaN layer (referred to as InGaN active layer, hereinafter) 3 as an active layer, and a p-type MgZnO layer 2 as a p-type cladding layer are epitaxially grown in this order, to thereby form a light emitting layer portion having a double heterostructure. The surface of the p-type MgZnO layer 2 is covered with the transparent conductive material layer 12 typically composed of ITO, the n-type AlGaN layer 4 and InGaN active layer 3 are partially removed, and on the exposed surface of the n-type AlGaN layer 4, a metal electrode 13 is formed. By establishing electric connection between the transparent conductive material layer 12 having a positive polarity and the metal electrode 13, light (blue light or ultraviolet radiation) from the light emitting layer portion is extracted from the transparent conductive material layer 12 side, or from the sapphire substrate 10 side. The metal electrode 13 herein can be composed of one or more selected from the group consisting of Au, Ni, Ti and Be, and typically of Au-Be alloy or the like.

Next, in the light emitting device 100 shown in Fig. 7, the protective layer is composed of a p-type compound semiconductor layer 20. The p-type compound semiconductor layer 20 can be used also as a current spreading layer. In this case, formation of a metal electrode 21 having an area smaller than that of the p-type compound semiconductor layer 20 makes it possible to extract light from the peripheral area, and this makes also possible to improve the light extraction efficiency because current from the electrode 21 can be spread over the entire area of the p-type MgZnO layer 2. The p-type compound semiconductor layer 20 in this case needs to have a sufficient transparency in view of allowing light extraction. In this embodiment, the p-type compound semiconductor layer 20 is composed of a p-type AlGaN layer, and thereon the metal electrode 21 is formed. Since other portions are same as those in the light emitting device 1 shown in Fig. 6, commonly used components are given with the identical reference numerals and instead detailed description will be omitted. It is to be noted that the metal electrode 21 is also omissible if the p-type compound semiconductor layer 20 has a sufficient conductivity.

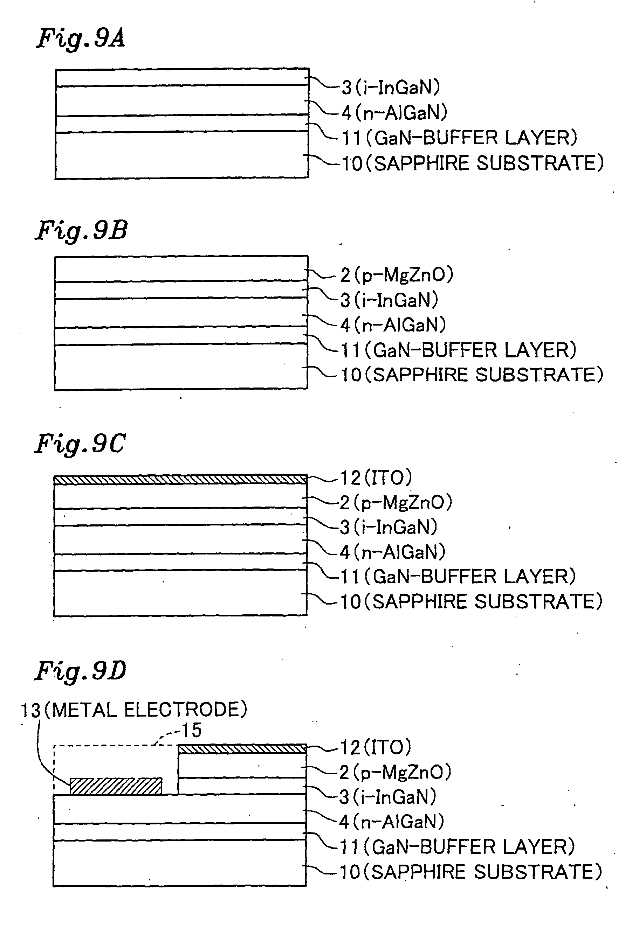

An exemplary method of fabricating the light emitting device 100 shown in Fig. 7 will be described referring to Figs. 9A to 9D.

First as shown in Fig. 9A, on one main surface of the sapphire substrate 10, the GaN buffer layer 11 is formed, and the n-type AlGaN layer (n-type cladding layer) 4 having a thickness of 50 nm for example, and the InGaN (non-doped) active layer 3 typically having a thickness of 30 nm for example are epitaxially grown. These layers can be formed by the publicly-known MOVPE process or MBE process. It is to be noted that, MBE in the context of this specification include not only MBE in a narrow sense in which both of a metal element component source and a non-metal element component source are used in solid forms, but also include MOMBE (metal organic molecular beam epitaxy) using the metal element component source in a form of organometallic compound and the non-metal element component in a solid form; gas source MBE using the metal element component source in a solid form and the non-metal element component in a gas form; and chemical beam epitaxy (CBE) using the metal element component source in a form of organometallic compound and the non-metal element component source in a gas form.

Next, as shown in Fig. 9B, the p-type MgZnO layer (p-type cladding layer) 2 is epitaxially grown typically in a thickness of 100 nm. Any metal element dopant used as the p-type dopant can be supplied in a form of organometallic compound containing at least one alkyl group.

When the p-type MgZnO layer 2 is formed by the MOVPE process, examples of the major materials include the followings:

- oxygen source: $NO_2$, etc.;
- Zn source: dimethyl zinc (DMZn), diethyl zinc (DEZn), etc.; and
- Mg source: bis-cyclopentadienyl magnesium ($Cp_2Mg$), etc.

Examples of the p-type dopant include the followings:

- Li source: n-butyl lithium, etc.;
- Si source: silicon hydrides such as monosilane;
- C source: hydrocarbons (for example, alkyl containing one or more C); and
- Se source: hydrogen selenide, etc.

One or more selected from the group consisting of Al, Ga and In can be allowed to function as excellent p-type dopants when added together with N. Sources of these elements include the followings:

- Al source: trimethyl aluminum (TMAl), triethyl aluminum (TEAl), etc.;
- Ga source: trimethyl gallium (TMGa), triethyl gallium (TEGa), etc.; and
- In source: trimethyl indium (TMIn), triethyl indium (TEIn), etc.

For the case where N is used together with a metal element (Ga) as p-type dopants, a gas which serves as an N source is supplied together with an organometallic compound which serves as a Ga source when the p-type MgZnO layer is grown in vapor phase. In the embodiment for example, $NO_2$ used as an oxygen source also serves as an N source.

Vapor-phase growth of the p-type MgZnO layer 2 based on the MOVPE process can be carried out by raising the temperature of an inner atmosphere of a growth furnace in which the substrate is housed to 300 to 700°C for example, and supplying the aforementioned source materials in a gas form together with a carrier gas. Available carrier gases include nitrogen gas and argon gas.

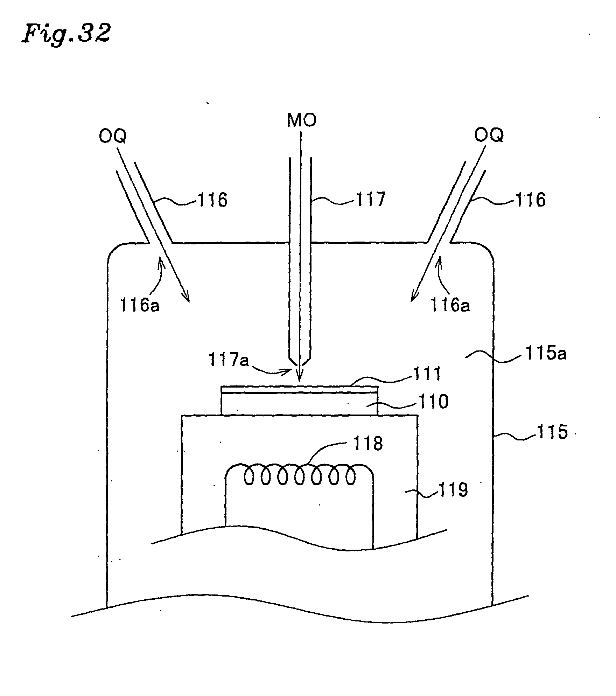

In the example shown in Fig. 32, the p-type $Mg_xZn_{1-x}O$ layer 2 is grown by the MOVPE process on the main surface 111 of a substrate 110 placed in an inner space 115a of a growth chamber 115. The substrate 110 is in the status shown in Fig. 9A, where the surface of the active layer 3 shown in Fig. 9A composes the main surface 111. In this case, it is advantageous to supply an oxygen-source gas OQ through an oxygen-source-gas exhaust ports 116a, and to supply an organimetallic compound MO which serves as an Mg and/or Zn source through organometallic compound exhaust port 117a located more closer to the main surface 111 than the oxygen-source-gas exhaust ports 116a, in view of obtaining the p-type $Mg_xZn_{1-x}O$ layer 2 having less oxygen deficiency (specifically $10/cm^3$ or less). It is more effective herein to raise the molar concentration of oxygen-source (Group VI) gas OQ to be supplied into the growth chamber 115 approx. 2,000 to 3,000 times higher than the molar concentration of the organometallic compound (Group II) MO (that is, to set supply II/VI ratio to 2,000 to 3,000).

In the embodiment shown in Fig. 32, the apparatus is designed to heat the substrate 110 using a built-in heater 118 of a susceptor 119. Openings of oxygen-source-gas exhaust supply ducts 116 connected to the growth chamber 115 compose the oxygen-source-gas exhaust ports 116a. The end portion of an organometallic compound supply duct 117 inserted in the growth chamber 115 is positioned in the upper vicinity of the main surface 111 on which the p-type $Mg_xZn_{1-x}O$ layer 2 is formed, where the organometallic compound exhaust port 117a is formed at the end portion thereof so as to blow the organometallic compound gas against the main surface 111.

It is effective to carry out the vapor-phase growth by keeping the inner pressure of the reaction chamber as high as $1.33 \times 10^3$ Pa (10 Torr). This ensures synthesis of the MgZnO layer in which oxygen disorption is effectively suppressed to thereby reduce oxygen deficiency, and having excellent p-type characteristics. In particular for the case where $NO_2$ is used as an oxygen source, the aforementioned pressure setting is advantageous because the $NO_2$ is prevented from rapidly dissociating, and the oxygen deficiency can more effectively be prevented from occurring.

The higher the atmospheric pressure rises, the more the oxygen disorption suppressive effect is enhanced, where a pressure at around $1.013 \times 10^5$ Pa (760 Torr, 1 atm) is effective enough. For example, the reaction chamber can be conditioned at normal pressure or at a reduced pressure by setting at $1.013 \times 10^5$ Pa (760 Torr), and only a relatively simple seal structure for the chamber will suffice. On the contrary, when a pressure exceeding $1.013 \times 10^5$ Pa (760 Torr) is adapted, a slightly tougher seal structure will be necessary in order to avoid leakage of the internal gas since the chamber is pressurized, and moreover, it will be even necessary to consider a pressure-resistant structure for the case where a considerably high pressure is adopted, where the oxygen disorption suppressive effect can further be improved. In this case, the upper limit of the pressure should be determined taking trade-off between cost of the apparatus and achievable oxygen-deficiency suppressive effect into account (typically $1.013 \times 10^6$ Pa (7,600 Torr, 10 atm) or around).

After the p-type MgZnO layer 2 is formed, the substrate is taken out from the reaction chamber, and then as shown in Fig. 9C, the transparent conductive layer 12 is formed. For the case where an ITO film is used, the formation can be carried out by RF sputtering or vacuum evaporation. Then as shown in Fig. 9D, a part of the p-type MgZnO layer 2 and the InGaN active layer 3 is removed typically by gas etching to thereby expose the n-type AlGaN layer 4, and thereon the metal electrode 13 is formed typically by vacuum evaporation. Thus the light emitting device 1 shown in Fig. 6 is completed. It is to be noted that, in order to fabricate the device in a proper size, after the process step shown in Fig. 9C, the substrate is diced, and thus-diced individual substrates is subjected to the process step shown in Fig. 9D. Although the process step is further followed by process steps of bonding of a current supply lead wire, resin molding and the like before the final product is obtained, these will not be detailed here since all of them are matters of common sense (the same will apply also to other embodiments described below). On the other hand, the light emitting device 100 shown in Fig. 7 can be fabricated according to the process steps similar to those as shown in Figs. 9A to 9D, except that, in succession to the p-type MgZnO layer 2, the p-type AlGaN layer is grown in a vapor phase typically by the MOVPE process, and thereon the metal electrode 21 is formed.

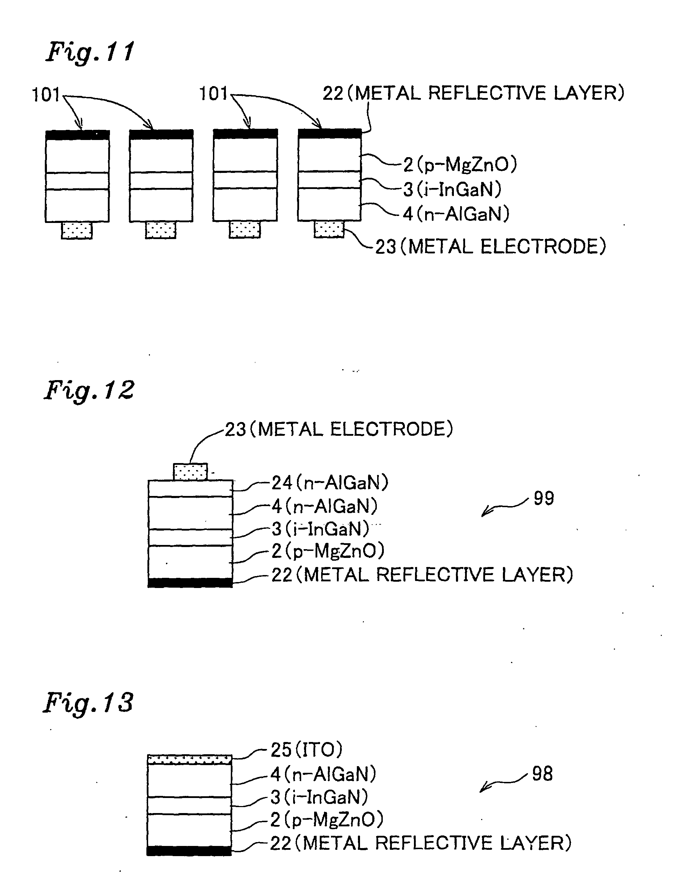

Next, a protective layer for the p-type MgZnO layer 2 can be composed also of a metal layer 22 as in a light emitting device 101 shown in Fig. 11. In this case, the metal layer 22 is also used as a light reflective layer (referred to as "metal reflective layer 22", hereinafter) for assisting light extraction from the n-type cladding layer 4 side. According to such constitution, light advances from the light emitting layer portion to the p-type cladding layer 2 can be reflected towards the n-type cladding layer (n-type AlGaN layer) 4 side to thereby further improve the light extraction efficiency. If an electrode is attached for example to the n-type cladding layer 4 side, the metal reflective layer (metal layer) 22 can, of course, be available as an electrode for supply current for light emission. In the light emitting device shown in Fig. 11, the metal electrode 23 is formed to the n-type cladding layer 4 so as to directly contact therewith and to partially cover the surface thereof. Light can be extracted from the area around the metal electrode 23. Unlike the light emitting devices 1, 100 shown in Figs. 6 and 7, the sapphire substrate is 10 has already been removed.

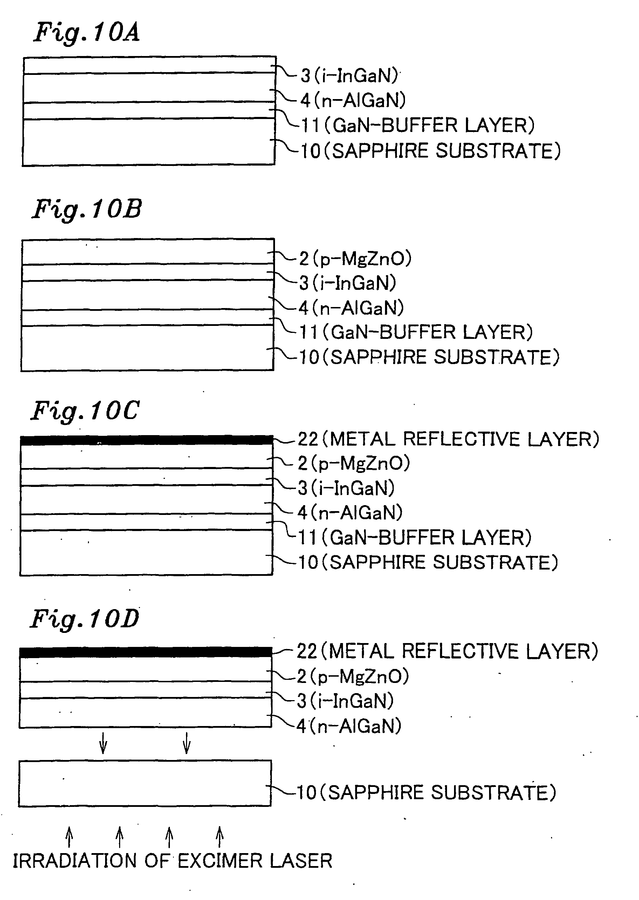

Fig. 10A to 10D show exemplary process steps for fabricating the light emitting device 101. A step of forming the buffer layer 11, and the individual layers 4, 3, 2 composing the light emitting layer portion shown in Fig. 10A is similar to that shown in Fig. 9A, and a step shown in Fig. 10B is similar to that shown in Fig. 9B. In Fig. 10C, in place of forming the ITO film, the metal reflective layer 22 such as an Au layer is formed typically by vacuum evaporation. In Fig. 10D, the sapphire substrate 10 is removed. For example, when the GaN buffer layer 11 is used, irradiation of excimer laser from the back surface of the sapphire substrate 10 melts the GaN buffer layer 11, and this makes it possible to readily separate and remove the sapphire substrate 10. It is to be noted that process steps shown in Figs. 10C and 10D can be exchanged. Then as shown in Fig. 11, the metal electrode 23 is formed on the back surface of the n-type cladding layer 4 from which the sapphire substrate 10 has already been removed, and dicing is carried out to thereby obtain the light emitting device 101. It is now also allowable to remove the sapphire substrate 10 by dissolving the buffer layer or other separating layer disposed separately from the buffer layer by chemical etching or the like.

As for a light emitting device 99 shown in Fig. 12, it is now also allowable to insert a current spreading layer 24 (n-type AlGaN layer, for example) between the metal electrode 23 and the n-type AlGaN layer. Or as for a light emitting device 98 shown in Fig. 13, it is also allowable to form a transparent conductive material layer 25 such as an ITO film in place of the metal electrode 23.

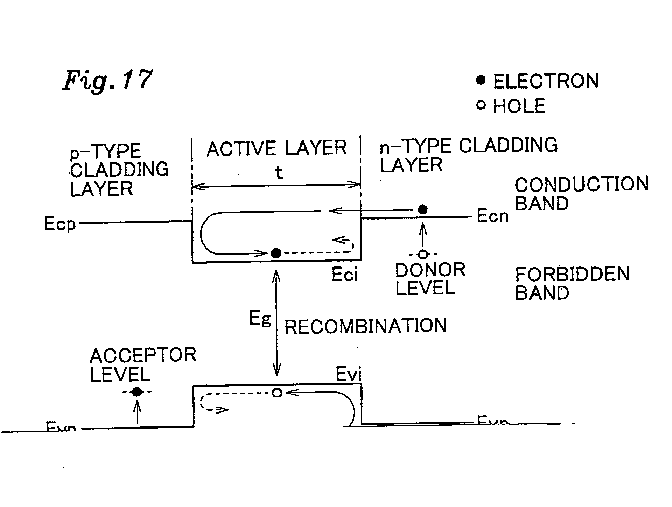

It is also allowable to form the active layer using a semiconductor capable of forming a type-I band lineup between itself and the p-type $Mg_xZn_{1-x}O$ layer. An example of such active layer is an $Mg_yZn_{1-y}O$ layer (where, $0 \leqq y < 1$, $x > y$). It is to be noted now that "a type-I band lineup is formed between the active layer and the p-type $Mg_xZn_{1-x}O$ layer" indicates a junction structure as shown in Fig. 17, in which the individual energy levels of the bottom of the conduction band and the upper end of the valence band $E_{cp}$, $E_{vp}$ of the p-type cladding layer (p-type $Mg_xZn_{1-x}O$ layer 2), and the individual energy levels of the bottom of the conduction band and the upper end of the valance band $E_{ci}$, $E_{vi}$ of the active layer satisfy the following relations of inequality:

$$E_{ci} < E_{cp} \tag{5}$$

$$E_{vi} > E_{vp} \tag{6}$$

In this structure, unlike the type-II band lineup shown in Figs. 8A and 8B, a potential barrier appears also for the forward diffusion of electrons (n-type carriers) from the active layer to the p-type cladding layer. If a material for the n-type cladding layer is selected so that the type-I band lineup similar to that shown in Figs. 8A and 8B is formed between the active layer and the n-type cladding layer, the active layer will have quantum wells both at the bottom of the conduction band and the upper end of the valence band, and this successfully raises confinement effect both for electrons and holes. This promotes carrier recombination, and further distinctively raises the emission efficiency. While a material composing the n-type cladding layer may be AlGaN, for example, as shown in Fig. 6, use of n-type $Mg_zZn_{1-z}O$ layer (where, $0 \leqq z < 1$) results in a considerable cost reduction because all layers constituting the light emitting layer portion can be composed of an MgZnO-base oxide material (thus-composed, light emitting layer portion is referred to as "full-oxide-type, light emitting layer portion", hereinafter), and it is no more necessary to use the above-described rare metals such as Ga and In (dopant excluded). If a relation is given as x=y, potential barrier heights on both sides of a quantum well are equalized.

The thickness "t" of the active layer is typically set to 30 to 1,000 nm so as not to cause lowering in the carrier density in the active layer, and so as not to excessively increase the amount of carrier possibly pass through the active layer based on the tunnel effect.

In the active layer composed of an $Mg_yZn_{1-y}O$ layer (referred to as "$Mg_yZn_{1-y}O$ active layer", hereinafter: where a case with y=0 also included), a value of "y" can also serve as a factor which determines band gap energy $E_g$. For example, the value is selected in a range of $0 \leqq y \leqq 0.5$ for the case where ultraviolet emission in a wavelength of 280 to 400 nm is intended. The barrier height of thus-formed well is preferably 0.1 to 0.3 eV or around for light emitting diode, and 0.25 to 0.5 eV or around for semiconductor laser light source. This value can be determined based on compositions of p-type $Mg_xZn_{1-x}O$ layer, $Mg_yZn_{1-y}O$ active layer, and n-type $Mg_zZn_{1-z}O$ layer, that is, based on selection of values for x, y and z. On the premise that the a quantum well structure is to be formed, containment of Mg is not essential for the active layer (that is, ZnO available), but essential for the p-type and n-type cladding layers.

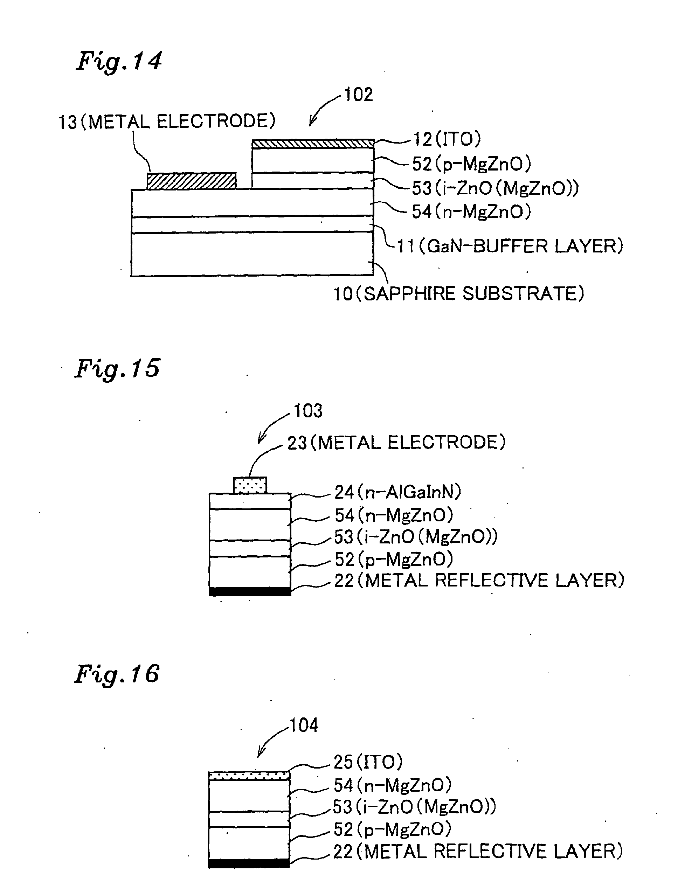

Fig. 14 shows a specific example of the light emitting device. In this light emitting device 102, an n-type $Mg_zZn_{1-z}O$ layer 54 as an n-type cladding layer, an $Mg_yZn_{1-y}O$ active layer 53, and p-type $Mg_xZn_{1-x}O$ layer 52 as a p-type cladding layer are epitaxially grown in this order to thereby form a light emitting layer portion having a double heterostructure. Since the other structures are same as that of the light emitting device 1 shown in Fig. 6, common portions will have the same reference numerals and detailed description therefor will be omitted. A light emitting device 103 shown in Fig. 15 corresponds to a device in which the light emitting layer portion of the light emitting device 99 shown in Fig. 12 is replaced with the aforementioned double heterostructure. In addition, a light emitting device 104 shown in Fig. 16 corresponds to a device in which the light emitting layer portion of the light emitting device 98 shown in Fig. 13 is replaced with the aforementioned double heterostructure.

It is now also allowable to form a structure of the light emitting device in which the $Mg_yZn_{1-y}O$ active layer 53 and the n-type $Mg_zZn_{1-z}O$ layer 54 have the same composition (i.e., y=z) but only differ in the carrier concentration, and the junction between both layers shown in Fig. 17 is homo junction. In this case, a single heterostructure is obtained in which a potential barrier generates only between the p-type $Mg_xZn_{1-x}O$ layer 52 and the $Mg_yZn_{1-y}O$ active layer 53 (z>y).

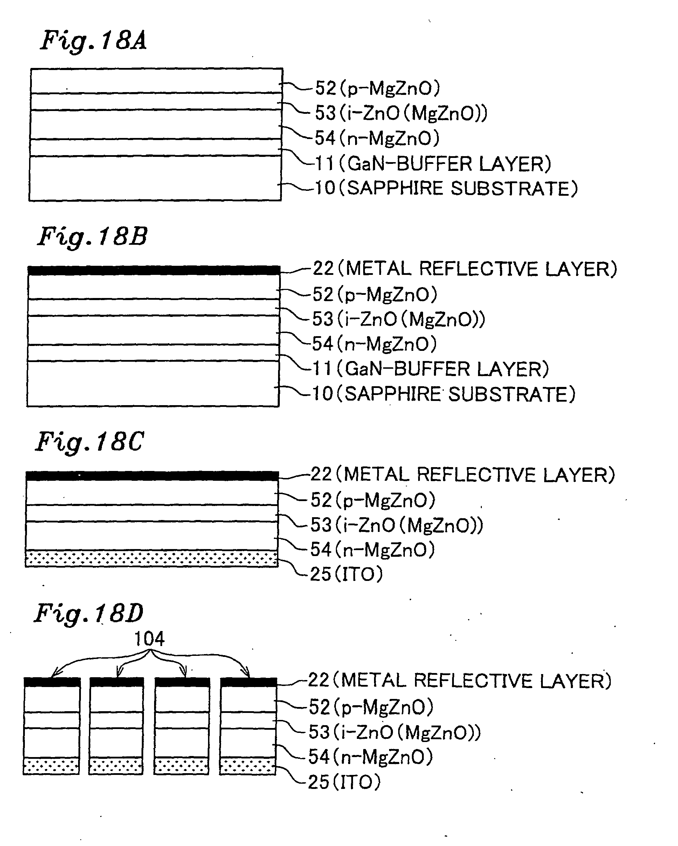

The following paragraphs will explain process steps for fabricating the light emitting device having the aforementioned full-oxide-type, light emitting layer portion referring to Figs. 18A to 18D, specially making reference to the light emitting device 104 shown in Fig. 16. First, as shown in Fig. 18A, the GaN buffer layer 11 is epitaxially grown on the sapphire substrate 10, and the n-type $Mg_zZn_{1-z}O$ layer 54 (typically 50 nm thick), the $Mg_yZn_{1-y}O$ active layer 53 (typically 30 nm thick) and the p-type $Mg_xZn_{1-x}O$ layer 52 (typically 50 nm thick) are formed in this order (order of the formation can be inverted). The epitaxial growth of the individual layers can be carried out by the MOVPE process similarly to the case of the light emitting devices 1, 100 shown in Figs. 6 and 7. While same source materials can be used when the MOVPE process is adopted, it is advantageous that all of the n-type $Mg_zZn_{1-z}O$ layer 54, the $Mg_yZn_{1-y}O$ active layer 53 and the p-type $Mg_xZn_{1-x}O$ layer 52 can be successively formed using the same source material in the same reaction chamber. On the other hand, in such constitution, the growth is preferably carried out at a slightly lower temperatures, 300 to 400°C for example, in order to reduce reactivity with the GaN buffer layer 11 and to improve lattice matching nature.

In this case, depending on difference in alloy compositions x, y and z, ratio of flow rates of organometallic compounds as an Mg source and a Zn source are controlled for the individual layers. When the $Mg_yZn_{1-y}O$ active layer 53 and the p-type $Mg_xZn_{1-x}O$ layer 52 are formed, it is preferable to adopt a method similarly to as already explained referring to Fig. 32 in order to suppress generation of oxygen deficiency. On the other hand, as for formation of the n-type $Mg_zZn_{1-z}O$ active layer 54, it is allowable to adopt a method by which oxygen deficiency is intentionally produced so as to obtain n-type conductivity. It is effective to lower the atmospheric pressure (e.g., $1.33\times10^3$Pa (10 Torr) than that in the formation of the $Mg_yZn_{1-y}O$ layer 53 and the p-type $Mg_xZn_{1-x}O$ layer 52. It is still also allowable to form the layer by separately introducing an n-type dopant. Or ratio of Group II and Group VI elements (supply II/VI ratio) of the source materials may be increased.

One example of possible process is such as follows. First, n-type $Mg_zZn_{1-z}O$ layer 54 of 50 nm thick is formed by the MOVPE process using $NO_2$, DEZn and $Cp_2Mg$ under an atmospheric pressure of $6.67\times10^2$ Pa (5 Torr) at approx. 300°C. Next, the $Mg_yZn_{1-y}O$ active layer 53 is formed under an atmospheric pressure of $1.013\times10^5$ to $1.013\times10^6$ Pa (760 to 7,600 Torr) at approx. 300°C. Finally, by introducing n-butyl lithium, for example, as a dopant gas, the p-type $Mg_xZn_{1-x}O$ layer 52 of 50 nm thick is formed at 300 to 400°C.

After the formation of the light emitting layer portion completed, the metal reflective layer 22 as a protective layer is formed on the p-type $Mg_xZn_{1-x}O$ layer 52 as shown in Fig. 18B, the sapphire substrate 10 is removed as shown in Fig. 18C, and the transparent conductive material layer 25 (e.g., ITO film) as a protective layer is formed on the n-type $Mg_zZn_{1-z}O$ layer 54. These process steps are similar to as described in the above. Thereafter, as shown in Fig. 18D, the light emitting device 104 is obtained after dicing. As is clear from this example, since both of the p-type cladding layer and the n-type cladding layer are composed of MgZnO, it is preferable to cover the surface of these layers, which are not in contact with the active layer, with the protective layer. It is to be noted now that, for the case where the growth substrate such as sapphire substrate is not removed but is used as a part of the device as in the light emitting device 102 shown in Fig. 14, the growth substrate *per se* also plays a role of the protective layer.

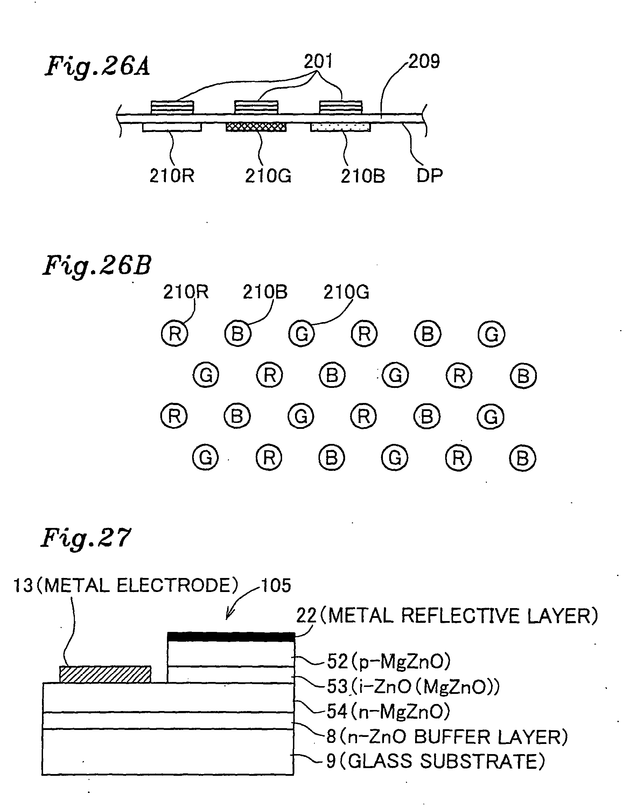

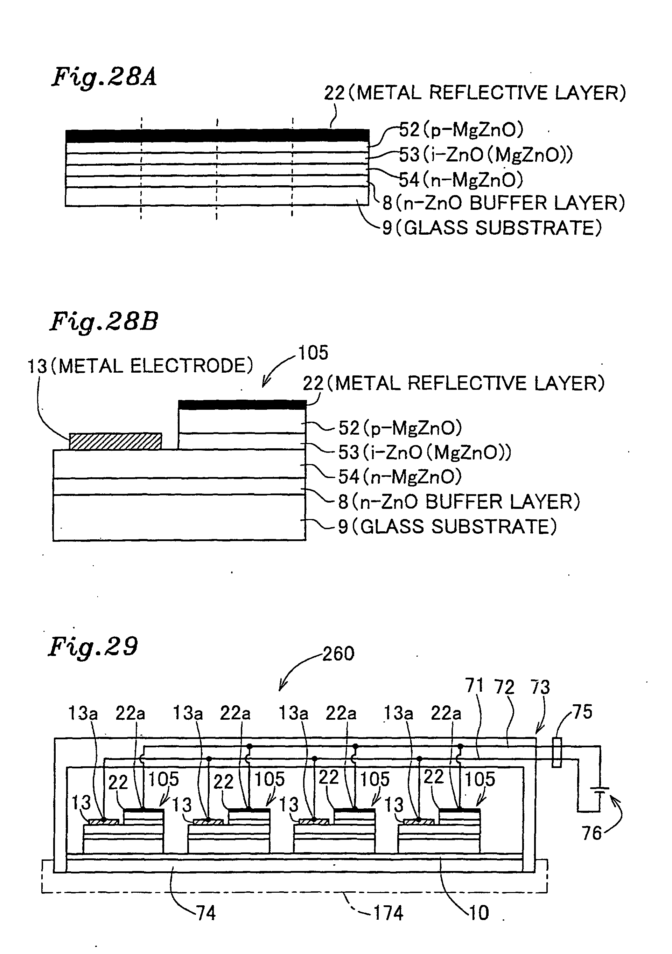

In the above-described method, the individual layers 52 to 54 were hetero-epitaxially grown as MgZnO single crystal layers by the MOVPE process, where the individual layers 52 to 54 can also be formed on a polycrysltal substrate or on a glass substrate 9 as in a light emitting device 105 shown in Fig. 27, because the light emitting layer portion composed only of an MgZnO layer can exhibit excellent emission characteristics even if it is composed of a polycrystal layer having c axis oriented along the thickness-wise direction as shown in Fig. 5B (in this embodiment, the thin n-type ZnO buffer layer 8 is formed on the glass substrate 9, and further thereon the individual layers 52 to 54 composing the light emitting layer portion are grown). For example, as shown in Fig. 28A, on the glass substrate 9, the n-type ZnO buffer layer 8 and the individual layer 52 to 54 composing the light emitting layer portion are formed by the low-temperature, vapor-phase growth method such as laser beam sputtering, the metal reflective layer 22 is formed, and the substrate is diced for separating devices. Then as shown in Fig. 28B, a part of the n-type $Mg_zZn_{1-z}O$ layer 54 is exposed, and the metal electrode 13 is formed thereon, to thereby obtain the light emitting device 105. The light emitting device 105 can extract light from the light emitting layer portion, together with reflected light from the metal reflective layer 22, through the glass substrate 9. It is to be noted now that another possible method of forming the individual layers 52 to 54 as the c-axis-oriented layer is the sol-gel process.

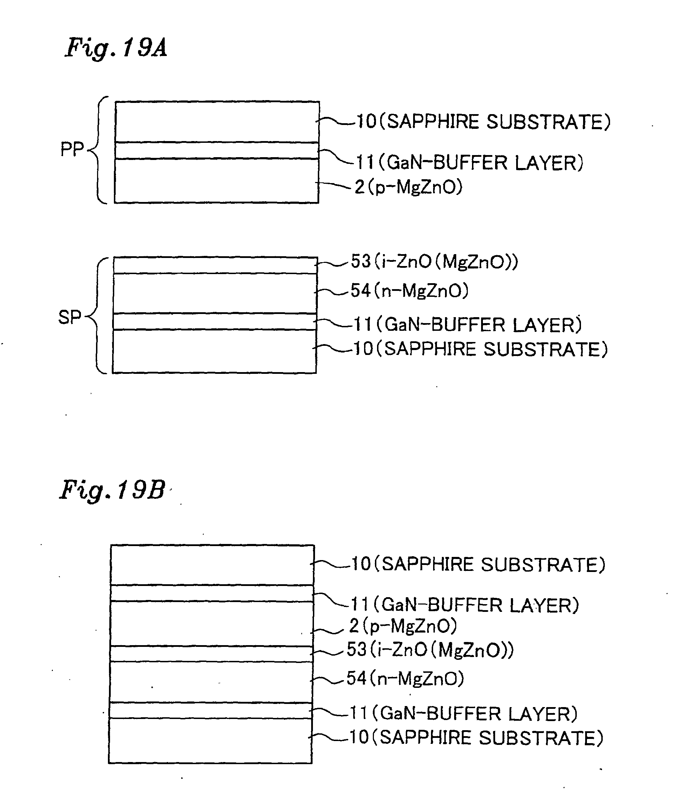

While the p-type $Mg_xZn_{1-x}O$ layer, active layer and n-type cladding layer composing the light emitting layer portion is sequentially stacked on the substrate in the aforementioned embodiment, similar stacked structure is obtainable also by the so-called bonding technique. For example, a primary portion and a secondary portion, which correspond to portions of the stacked structure, composed of the p-type $Mg_xZn_{1-x}O$ layer, active layer and n-type cladding layer, divided into two on one side of the active layer, are separately formed respectively on the substrate, and then bond the primary and secondary portions. Figs. 19A and 19B shows specific example of the process. As shown in Fig. 19A, the primary portion PP include the p-type $Mg_xZn_{1-x}O$ layer 2. In this embodiment, on the sapphire substrate 10, the p-type $Mg_xZn_{1-x}O$ layer 2 is epitaxially grown interposing the GaN buffer layer 11 therebetween. On the other hand, the secondary portion SP includes the stacked structure which is composed of the active layer 53 and the n-type cladding layer 54. That is, on the sapphire substrate 10, the GaN buffer layer 11 is formed, and further thereon the n-type $Mg_zZn_{1-z}O$ layer 54 and the $Mg_yZn_{1-y}O$ active layer 53 are epitaxially grown. Such primary portion PP and secondary portion SP are stacked so as to oppose the $Mg_yZn_{1-y}O$ active layer 53 with the p-type $Mg_xZn_{1-x}O$ layer 2, and then annealed at a proper temperature (e.g., 300 to 500°C or around) to thereby bond them.

Next paragraphs will describe exemplary applications of the light emitting device of the invention.

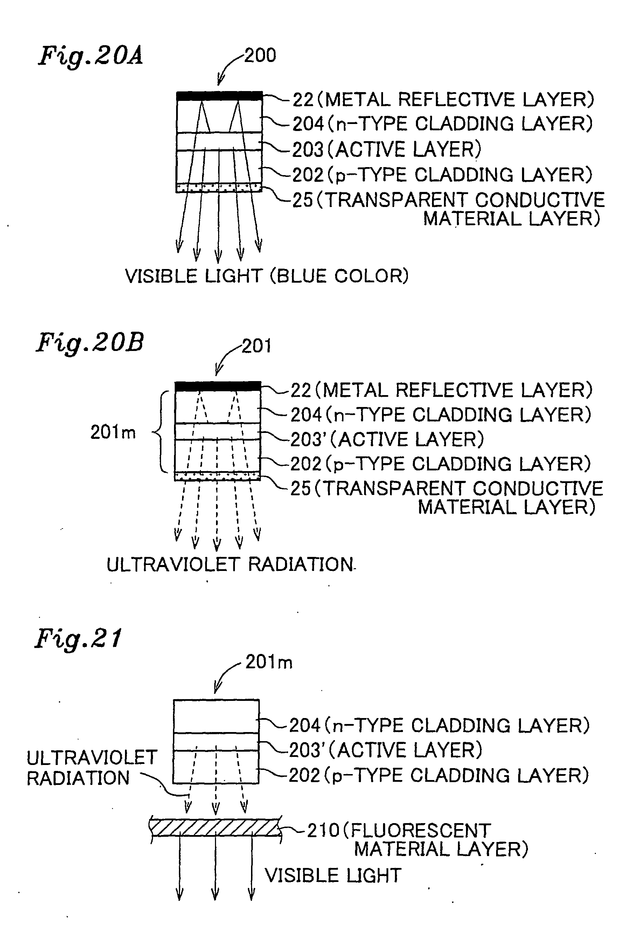

As has been described in the above, the light emitting device of the invention can be composed as a visible-light emitting device 200 as shown in Fig. 20A, or as a ultraviolet emitting device 201 as shown in Fig. 20B, by proper selection of band gap of the active layer. The examples shown in Fig. 20A and 20B are designed to extract light generated in the active layers 203, 203' from the transparent conductive material layer 25 side, which is formed on the p-type cladding layer 202 side, after being reflected by the metal reflective layer 22 formed on an n-type cladding layer 204 side. Formation style of the electrode or the like and light extraction style are, however, not limited thereto, and various styles as shown in Figs. 6, 7, 11, 12 and 27 are of course allowable.

The light emitting device composed as the visible-light emitting device 200 can of course be applicable to general display purposes. In particular, achievement of high-luminance blue light emission can realize a compact full-color display apparatus or full-color LED display having an advanced performance and low power consumption. The light emitting device, including that used as the ultraviolet emitting device 201, is available as a light source for optical-fiber communication or a spot light source for photo-coupler. The former is advantageous in dramatically improving information transfer density. by virtue of high-luminance, short-wavelength light emission. While the light emitting device of the invention is of course available as a laser light source, the device can also compose a small-sized, lightweight short-wavelength laser emission unit, and can dramatically increase recording density if it is used as a laser light source for optical recording.

The invention also achieves a semiconductor-base, ultraviolet emitting device, and this makes it possible to realize a overwhelming weight reduction, downsizing, energy saving and life elongation as compared with those for the conventional ultraviolet light source based on electrode discharge.

It is also expected that a novel type of visible-light emitting apparatus can be realized by combining a semiconductor ultraviolet, light emitting device having a light emitting layer portion 201m in which the p-type cladding layer 202, an active layer 203' and the n-type cladding layer 204 are stacked in this order, with a fluorescent material 210. More specifically, in response to ultraviolet irradiation from the semiconductor ultraviolet emitting device, the photo-excited fluorescent material 210 emits visible light. While this is basically identical to fluorescent lamp and CRT (cathode ray tube) in principle, a critical difference resides in that the apparatus uses a semiconductor light emitting device as a ultraviolet source. Effects brought by such constitution were already described in "Disclosure of the Invention" in the above. A specific embodiment of the apparatus will be detailed below.

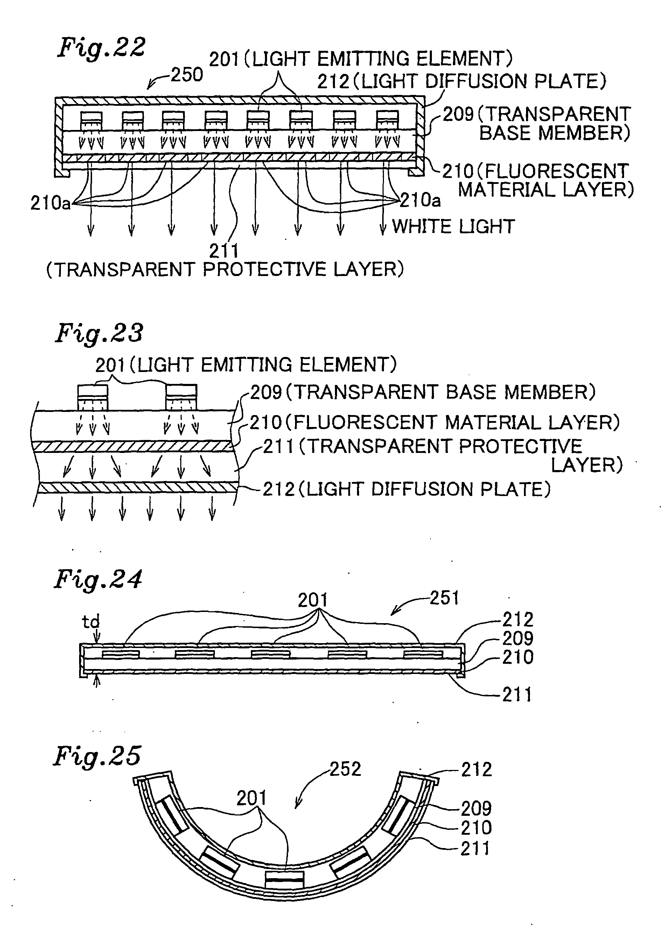

First, as shown in Fig. 22, the apparatus can be designed so that ultraviolet radiation from the semiconductor ultraviolet, light emitting device (also simply referred to as light emitting device) 201 is irradiated to the fluorescent material layer 210 formed on a base member 209. Use of such base member 209 allows arbitrary selection of shape of the light emitting portion of the apparatus depending on shape of the base member 209, and is thus advantageous in that flexible design of the outer appearance of the apparatus is allowable depending on purposes. For example in a light emitting device 250 shown in Fig. 22, both of the base member 209 and the fluorescent material layer 210 are formed in a planar form. This largely contributes to space saving. For example, by forming the base member 209 in a form of thin plate and forming the fluorescent material layer 210 thereon, the light emitting layer portion can intrinsically be made very thin, and thus an extra-thin design (typically having a thickness td of 10 mm or below, or 5 mm or below, where thinning even as thin as 1 mm or around also possible) of a high-luminance light emitting apparatus 251. It is also allowable to use a curved base member 209 as shown in Fig. 25.

Since the light emitting apparatuses 250, 251 and 252 shown in Figs. 22, 24 and 25 are common in their individual components except for the shape thereof, a detailed description will representatively be made on the light emitting apparatus 250 shown in Fig. 22. The light emitting device 201 are disposed in a plural number, and the ultraviolet radiation from the individual light emitting devices 201 are dedicated for light emission of the correspondent fluorescent material layers 210. Such design is advantageous in that the light emission area of the apparatus can readily be enlarged. The light emitting apparatus 250 is a lighting apparatus designed so that a plurality of the light emitting devices 201 concomitantly allow the correspondent fluorescent material layer to emit light, and has a large area and long service life.

The fluorescent material layer 210 herein has portions 210a corresponded to the plurality of light emitting devices 201 laterally integrated in line, and this constitution can readily be fabricated because the portions 210a of the fluorescent material layer can be formed in an integrated manner as a single fluorescent material layer 210. In this case, assuming that the portions 210a of the fluorescent material layer are portions covered by the light emitting devices 201, it is also possible to allow ultraviolet radiation from the light emitting device 201 to spread outwardly from the portions 210a of the fluorescent material layer, and consequently to generate light emission in an area broader than that of the portions 210a of the fluorescent material layer, depending on the distance between the light emitting devices 201 and such portions 210a of the fluorescent material layer. Therefore, even if a slight gap is formed between every adjacent light emitting devices 201, 201, visible-light emitting areas of the fluorescent material layer 210 ascribable to the ultraviolet radiation from the individual light emitting devices 201, 201 can be connected with each other by properly adjusting the distance between the fluorescent material layer 210 and the light emitting devices 201, and this successfully produces uniform light emission having less irregularity over the entire surface of the fluorescent material layer 210.

In the light emitting apparatus 250, the base member is composed of the transparent substrate 209, and on one surface of the transparent substrate 209 the fluorescent material layer 210 is formed. The light extraction plane of the light emitting devices 201 is disposed on the opposite surface (disposed in contact herein), so as to allow ultraviolet radiation from the light emitting devices 201 (semiconductor ultraviolet emitting devices) to irradiate the fluorescent material layer 210 through the transparent substrate 209. This design allows the light emitting devices 201 (semiconductor ultraviolet emitting device) and the fluorescent material layer 210 to be separately disposed on both surfaces of the transparent substrate 209, and this is further effective in reducing the size and simplifying the constitution of the apparatus.

The transparent substrate 209 can be composed of a glass plate or transparent plastic (e.g., acrylic resin). While the light emitting devices 201 can be disposed on the transparent substrate 209 by bonding the light extraction planes thereof using an adhesive or the like, it is also allowable to grow the light emitting layer portion of the light emitting devices 201 on the glass plate. For the case where there is a need for connecting the visible-light emitting areas of the fluorescent material layer 210 corresponded to the individual light emitting devices 201, the thickness of the transparent substrate 209 is properly adjusted so as to spread the ultraviolet radiation to an extent causative of such connection. On the contrary, close disposition of the light emitting devices 201 to the fluorescent material layer 210 reduces the spreading of ultraviolet radiation, and this is advantageous in terms of improving definition of the pixels in applications such as display apparatuses described later.

In the light emitting apparatus 250 shown in Fig. 22, the surface of the fluorescent material layer 210 is covered with a transparent protective layer 211 composed typically of a transparent plastic. The side of the transparent substrate 209 on which the light emitting devices 201 are disposed is covered with a case 212. As another possible way to produce uniform light emission with less irregularity, a constitution is shown in Fig. 23, in which the light is extracted through a light diffusion plate 212. In this embodiment, the transparent protective layer 211 is disposed between the fluorescent material layer 210 and the light diffusion plate 212.

Any light emitting materials are available provided that they can be excited to emit ultraviolet radiation. For the case where white light emission is desired, publicly-known fluorescent material, such as calcium halophosphate ($3Ca_3(PO_4)_2 \cdot CaFCl/Sb, Mn$), used in fluorescent lamp or the like are available, where contents of F, Cl/Sb and Mn are properly adjusted to obtain various white lights having a variety of color temperatures. It is also possible to realize lighting with an improved color rendering by combining narrow-band emission sources in three wavelength regions for red, green and blue (RGB). In this case, fluorescent materials of the individual colors are used in a mixed form, where a

representative combination is $Y_2O_3$:$Eu^{3+}$ (R: center wavelength = 611 nm), $CeMgAl_{11}O_{19}$:$Tb^{3+}$ (G: center wavelength = 543 nm) and $BaMg_2Al_{16}O_{27}$:$Eu^{2+}$ (B: center wavelength = 452 nm).

Next, as shown in Figs. 26A and 26B, the fluorescent material layer may be composed of separate portions (210R, 210B, 210B) corresponded to the individual light emitting devices 201. This design is of course applicable to lighting apparatus, and further important in view of being applied to display apparatus. For this purpose, the light emitting devices 201 are designed so as to be independently controllable of ultraviolet emitting status, each display unit is defined as being composed of a set of an individual light emitting device 201 and a correspondent fluorescent material layer (201/210R, 201/210G, 201/210B), and a plurality of such display units are arrayed along a display plane DP (composed of the surface of the transparent substrate 209). Fig. 26B shows an exemplary array for color display, where RGB fluorescent material layers 210R, 210G, 210B are disposed so as to avoid adjacent placement of the same color. Using the fluorescent material layers 210R, 210G, 210B of the individual display units as pixels, an image is display based on combination of light emission status of the pixels.

The display apparatus based on such system has various advantages;

- unlike CRTs and plasma displays, the display apparatus has no filament, electrode nor electron gun as a ultraviolet radiation source so as to ensure a long service life, and power consumption is small by virtue of lower drive voltage;
- successfully thinned to an extent equivalent to that of liquid-crystal displays, needs no backlight or so since it is a self-illumination apparatus, and almost not causative of directional dependence in the visibility; and
- a constitution using the full-oxide, light emitting layer portion (shown in Fig. 16 or the like) allows easy patterning of the light emitting layer portion corresponding to the pixels by chemical etching, because MgZnO can readily be solubilized into a dilute acid or alkali. Thus a high-definition display having a fine pixels can readily be obtained. It is now also possible to compose an LED display in which the visible-light emitting devices 200 shown in Fig. 20A are directly used as the pixels without using the fluorescent material, where use of the full-oxide-type, light emitting layer portion will make the LED display far more reduced in size and improved in definition.

The above-described lighting apparatuses and display apparatuses allow various compositional forms including current supply wiring to the light emitting device 201 to be used, where several examples thereof will be explained below. Fig. 29 shows a thin lighting apparatus 260, in which a fluorescent material layer 10 is disposed on the back side of a transparent plate 74 typically composed of an acrylic plate, and further thereon a plurality of the light emitting devices 105 (using glass substrate 9: method of fabrication thereof already explained referring to Figs. 28A and 28B) shown in Fig. 27 are bonded using an adhesive (the thickness of the light emitting layer portion emphasized in the drawing, and is practically more thinner). The assembly is further stacked with a wiring board having formed thereon a current supply wirings 71, 72 and electrode terminals 13a, 22a corresponded to the electrodes 13, 22, respectively, of the individual devices 105, and the entire assembly is molded in a case 73 (in this embodiment, the wiring board forms a part of the case 73). On the case 73, a connector is formed so as to draw out the each end of the current supply wirings 71, 72. By connecting a power source 76 thereto, the individual devices 105 are supplied with current.

A DC power source can of course be available as the power source 76, but also it can be driven by pulsating current obtained after rectifying AC current, and even direct drive with AC current is allowable if the half-wave waveform is of no problem.

In the conventional fluorescent lamps, addition of a dimming function concomitantly needed warming of the electrode and AC phase control, but this inevitably makes the circuit constitution more complicated, and thus the function was only applicable to lighting facility of higher grade (those effecting dimming through series impedance switching also available, but are considerably uneconomical). On the contrary, the lighting apparatus 260 of the invention is advantageous in that the dimming is facilitated without using a complicated circuit constitution, which can be realized by using a system by which supply voltage to the light emitting device 105 is varied, or a system by which an average current is varied based on control of the duty ratio.

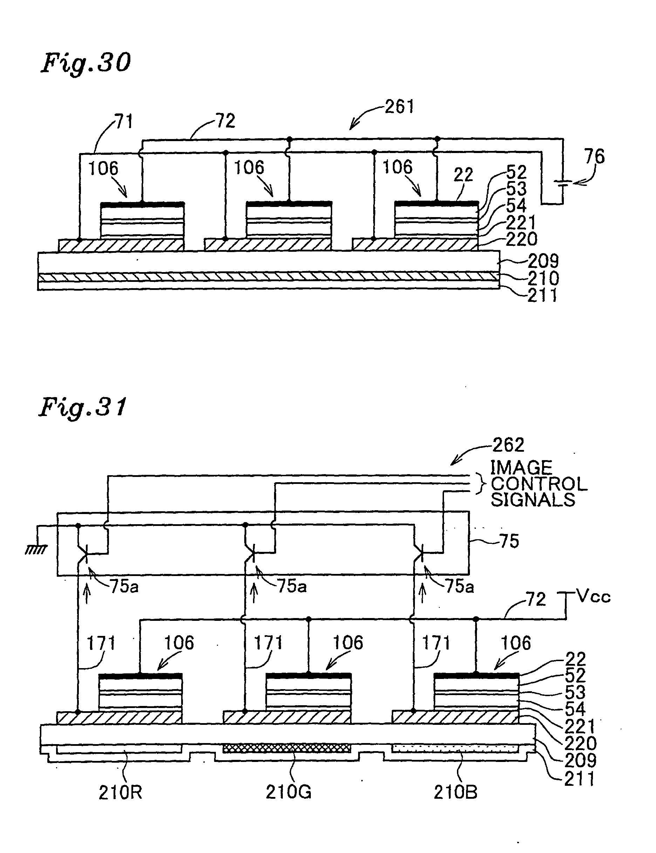

Next, Fig. 30 shows a lighting apparatus 261 in which the light emitting layer portions 53, 54, 52 of light emitting devices 106 are grown on a glass substrate 209 as the transparent substrate. The fluorescent material layer 210 and the transparent protective film 211 are formed on one surface of the glass substrate 209, and on the opposite surface, a pattern of an electrode layer 220, composed of a transparent conductive material such as ITO, is formed so as to be corresponded to the formation sites of the individual light emitting devices 106 typically by photolithography. And further thereon, the full-oxide-type, light emitting layer portions 54, 53, 52 are sequentially formed while placing an appropriate buffer layer 221 in between, and then patterned by chemical etching so as to expose a part of the individual electrode layer 220, to thereby separate the light emitting layer portions of the individual devices 106. Finally, metal reflective film 22 is formed for each of the light emitting layer portions, necessary wirings 71, 72 are formed, to thereby complete the lighting apparatus 261.

Fig. 31 shows a lighting apparatus 262. On one surface of the glass substrate 209, the RGB fluorescent material layers 210R, 210G, 210B composing the pixels are formed, and are covered with the transparent protective layer 211. On the opposite surface of the glass substrate 209, the light emitting devices 106 similar to those in the lighting apparatus 261 shown in Fig. 30 are formed in positions corresponded to the individual fluorescent material layers 210R, 210G, 210B (the same reference numerals given for the portions commonly found in Fig. 30). The individual light emitting device is controlled as being supplied with current by a control circuit 75 based on the respective image control signals. While the embodiment exemplifies a most simplified constitution in which the individual light emitting devices are switched using transistors 75a, emission luminance of the pixels can be changed in a step-wise manner if the control circuit 75 is composed so as to effect independent control of supply current to the individual light emitting devices 106.

## Claims

1. A light emitting device having a light emitting layer portion in which an n-type cladding layer, an active layer and a p-type cladding layer are stacked in this order, the p-type cladding layer being composed of a p-type $Mg_xZn_{1-x}O$ (where, $0<x\leqq1$) layer.

2. The light emitting device as claimed in Claim 1, wherein the p-type $Mg_xZn_{1-x}O$ layer contains N, and one or more selected from the group consisting of Ga, Al and In as the p-type dopant.

3. The light emitting device as claimed in Claim 1 or 2, wherein the active layer is composed of a semiconductor capable of forming type-II band lineup with respect to the p-type $Mg_xZn_{1-x}O$ layer.

4. The light emitting device as claimed in any one of Claims 1 to 3, wherein the active layer is an InGaN layer.

5. The light emitting device as claimed in Claim 1 or 2, wherein the active layer is composed of a semiconductor capable of forming type-I band lineup with respect to the p-type $Mg_xZn_{1-x}O$ layer.

6. The light emitting device as claimed in any one of Claims 1, 2 and 5, wherein the active layer is an $Mg_yZn_{1-y}O$ layer (where, $0\leqq y<1$ and $x>y$).

7. The light emitting device as claimed in Claim 6, wherein the n-type cladding layer is an n-type $Mg_zZn_{1-z}O$ layer (where, $0\leqq z<1$).

8. The light emitting device as claimed in any one of Claims 1 to 7, wherein the surface of the p-type $Mg_xZn_{1-x}O$ layer opposite to that in contact with the active layer is covered with a protective layer which comprises a conductive material or a semiconductor material.

9. The light emitting device as claimed in Claim 8, wherein the p-type $Mg_xZn_{1-x}O$ layer has a structure in which oxygen-ion-packed layers and metal-ion-packed layers are alternately stacked in the thickness-wise direction, and the protective layer is in contact with the oxygen-ion packed layer.

10. The light emitting device as claimed in Claim 8 or 9, wherein the protective layer is a transparent conductive material layer.

11. The light emitting device as claimed in Claim 10, wherein the transparent conductive material layer is used also as an electrode for supplying current for light emission.

12. The light emitting device as claimed in Claim 8 or 9, wherein the protective layer is a p-type compound semiconductor layer.

13. The light emitting device as claimed in Claim 12, wherein the p-type compound semiconductor layer is used also as a current spreading layer.

14. The light emitting device as claimed in Claim 8 or 9, wherein the protective layer is a metal layer.

15. The light emitting device as claimed in Claim 14, wherein the metal layer is used also as a light reflective layer for assisting light extraction from the n-type cladding layer side.

16. The light emitting device as claimed in Claim 14 or 15, wherein the metal layer is used also as an electrode for supplying emission current.

17. The light emitting device as claimed in any one of Claims 1 to 16, wherein the semiconductor composing the active layer is selected so as to have a band gap energy causative of light emission in the visible light wavelength from 400 to 570 nm.

18. The light emitting device as claimed in any one of Claims 1 to 16, wherein the semiconductor composing the active layer is selected so as to have a band gap energy causative of light emission in the ultraviolet wavelength from 280 to 400 nm.

19. A method of fabricating the light emitting device of any one of Claims 1 to 18, wherein the p-type $Mg_xZn_{1-x}O$ layer is formed by the metal organic vapor-phase epitaxy process.

20. The method of fabricating the light emitting device as claimed in Claim 19, wherein the metal organic vapor-phase epitaxy process is carried out in an atmosphere conditioned at a pressure of $1.33 \times 10^3$ Pa or above.

21. The method of fabricating the light emitting device as claimed in Claim 19 or 20, wherein a metal element dopant is used as the p-type dopant, and the metal element dopant is supplied in a form of an organometallic compound containing at least one alkyl group, during the vapor-phase growth of the p-type $Mg_xZn_{1-x}O$ layer.

22. The method of fabricating the light emitting device as claimed in Claim 21, wherein the metal element dopant is any one or more selected from the group consisting of Ga, Al, In and Li.

23. The method of fabricating the light emitting device as claimed in Claim 22, wherein any one or more selected from the group consisting of Ga, Al, In and Li are used together with N as the p-type dopant, and during the vapor-phase growth of the p-type $Mg_xZn_{1-x}O$ layer, an N-source gas is supplied together with the organometallic compound used as a source for the metal element dopant.

24. The method of fabricating the light emitting device as claimed in any one of Claims 19 to 23, wherein the n-type cladding layer, the active layer and the p-type $Mg_xZn_{1-x}O$ layer are formed so as to be sequentially stacked on a substrate.

25. The method of fabricating the light emitting device as claimed in any one of Claims 19 to 23, wherein the stacked structure of the n-type cladding layer, the active layer and the p-type $Mg_xZn_{1-x}O$ layer is formed so that a primary portion and a secondary portion thereof, which are corresponded to the portions of the stacked.structure divided in two on one side of the active layer, are separately formed on the substrate, and the primary portion and the secondary portion are then bonded.

26. The method of fabricating the light emitting device as claimed in Claim 25, wherein the primary portion includes the p-type $Mg_xZn_{1-x}O$ layer, and the secondary portion includes a stacked structure of the n-type cladding layer and the active layer.

27. The method of fabricating the light emitting device as claimed in any one of Claims 19 to 26, wherein, during formation of the p-type $Mg_xZn_{1-x}O$ layer on the main surface of the substrate placed in the inner space of a growth chamber according to the metal organic vapor-phase epitaxy process, an oxygen-source gas is supplied through an oxygen-source gas exhaust port, and the organometallic compound used as an Mg and/or Zn source is supplied through an organometallic compound exhaust port located more closer to the main surface of the substrate than the oxygen-source gas exhaust port.

28. A visible-light emitting apparatus having a light emitting layer portion in which an n-type cladding layer, an active layer and a p-type cladding layer are stacked in this order, the p-type cladding layer further comprising a semiconductor ultraviolet emitting device composed of a p-type $Mg_xZn_{1-x}O$ (where, $0<x\leqq1$) layer, and a fluorescent material which emits visible light as being irradiated by ultraviolet radiation from the semiconductor ultraviolet emitting device.

29. The visible-light emitting apparatus as claimed in Claim 28, wherein the ultraviolet radiation from the semiconductor ultraviolet emitting device is irradiated on a fluorescent material layer formed on a base member.

30. The visible-light emitting apparatus as claimed in Claim 29, wherein the semiconductor ultraviolet emitting device is disposed in a plural number, and the ultraviolet radiation from the individual semiconductor ultraviolet emitting devices are dedicated for light emission of the correspondent fluorescent material layers.

31. The visible-light emitting apparatus as claimed in Claim 30, wherein the apparatus is composed as a lighting apparatus designed so that a plurality of the semiconductor ultraviolet emitting devices concomitantly allow the correspondent fluorescent material layer to emit light.

32. The visible-light emitting apparatus as claimed in Claim 31, wherein the fluorescent material layers corresponded to the individual semiconductor ultraviolet emitting devices are laterally integrated in line.

33. The visible-light emitting apparatus as claimed in Claim 30, wherein the apparatus is composed as a display apparatus in which a plurality of display units are arrayed along a display plane,

the display units respectively comprising a set of an independently-controllable semiconductor ultraviolet emitting

device and a correspondent fluorescent material layer, so as to make, using the fluorescent material layers of the individual display units as pixels, image display based on combination of light emission status of the pixels.

34. The visible-light emitting apparatus as claimed in any one of Claims 29 to 33, wherein the base member and the fluorescent material layers are formed in a planar form.

35. The visible-light emitting apparatus as claimed in any one of Claims 29 to 34, wherein the base member is composed as a transparent substrate, the fluorescent material layers are formed on one surface of the transparent substrate, light extraction plane of the semiconductor ultraviolet emitting devices are opposingly disposed on the opposite surface thereof, so as to allow the ultraviolet radiation from the semiconductor ultraviolet emitting devices to irradiate the fluorescent material layers through the transparent substrate.

*Fig. 1*

| | |
|---|---|
| PROTECTIVE LAYER | 35 |
| | ← OXYGEN-ION-PACKED PLANE |
| p-MgZnO (p-TYPE CLADDING LAYER) | 2 |
| | ← METAL-ION-PACKED PLANE |
| ACTIVE LAYER | 33 |
| n-TYPE CLADDING LAYER | 34 |

*Fig.2*

○ : OXYGEN

● : ZINC OR MAGNESIUM

*Fig.3*

MgZnO
LAYER 2

← METAL-ION-PACKED
PLANE

← OXYGEN DEFICIENCY

← OXYGEN-ION-PACKED
PLANE

C-AXIS DIRECTION

18

*Fig.4*

ATMOSPHERIC PRESSURE

"O"　"O"　"O"　"O"　——O

●　●　●　●　●——Mg OR Zn

○　○　○　○——O

●　●　●　●　●——Mg OR Zn

*Fig.5A*

MgZnO SINGLE
CRYSTAL LAYER

*Fig.5B*

MgZnO COLUMNAR
GRAINS

*Fig.6*

13(METAL ELECTRODE) 1

12(ITO)
2(p-MgZnO)
3(i-InGaN)
4(n-AlGaN)
11 (GaN-BUFFER LAYER)
10 (SAPPHIRE SUBSTRATE)

*Fig.7*

100

13(METAL ELECTRODE)

21(METAL ELECTRODE)
20(p-AlGaN)
2(p-MgZnO)
3(i-InGaN)
4(n-AlGaN)
11(GaN-BUFFER LAYER)
10(SAPPHIRE SUBSTRATE)

20

## Fig.8A

p-TYPE CLADDING LAYER | ACTIVE LAYER | n-TYPE CLADDING LAYER

CONDUCTION BAND

$E_{cn}$

DONOR LEVEL — FORBIDDEN BAND

$E_{ci}$

$E_{cp}$

$E_g$ | RECOMBINATION

ACCEPTOR LEVEL

$E_{vi}$

$E_{vp}$ — $E_{vn}$

VALENCE BAND

## Fig.8B

p-TYPE CLADDING LAYER | ACTIVE LAYER | n-TYPE CLADDING LAYER

CONDUCTION BAND

$E_{cn}$

$E_{ci}$

FORBIDDEN BAND

$E_{cp}$

$E_{vi}$

$E_{vp}$ — $E_{vn}$

VALENCE BAND

*Fig.9A*

~3 (i-InGaN)
~4 (n-AlGaN)
~11 (GaN-BUFFER LAYER)
~10 (SAPPHIRE SUBSTRATE)

*Fig.9B*

~2 (p-MgZnO)
~3 (i-InGaN)
~4 (n-AlGaN)
~11 (GaN-BUFFER LAYER)
~10 (SAPPHIRE SUBSTRATE)

*Fig.9C*

~12 (ITO)
~2 (p-MgZnO)
~3 (i-InGaN)
~4 (n-AlGaN)
~11 (GaN-BUFFER LAYER)
~10 (SAPPHIRE SUBSTRATE)

*Fig.9D*

13 (METAL ELECTRODE)
~15

~12 (ITO)
~2 (p-MgZnO)
~3 (i-InGaN)
~4 (n-AlGaN)
~11 (GaN-BUFFER LAYER)
~10 (SAPPHIRE SUBSTRATE)

*Fig.10A*

~3(i-InGaN)
~4(n-AlGaN)
~11(GaN-BUFFER LAYER)
~10(SAPPHIRE SUBSTRATE)

*Fig.10B*

~2(p-MgZnO)
~3(i-InGaN)
~4(n-AlGaN)
~11(GaN-BUFFER LAYER)
~10(SAPPHIRE SUBSTRATE)

*Fig.10C*

~22(METAL REFLECTIVE LAYER)
~2(p-MgZnO)
~3(i-InGaN)
~4(n-AlGaN)
~11(GaN-BUFFER LAYER)
~10(SAPPHIRE SUBSTRATE)

*Fig.10D*

~22(METAL REFLECTIVE LAYER)
~2(p-MgZnO)
~3(i-InGaN)
~4(n-AlGaN)

~10(SAPPHIRE SUBSTRATE)

IRRADIATION OF EXCIMER LASER

## Fig.11

101      101      22 (METAL REFLECTIVE LAYER)

2 (p-MgZnO)
3 (i-InGaN)
4 (n-AlGaN)

23 (METAL ELECTRODE)

## Fig.12

23 (METAL ELECTRODE)

24 (n-AlGaN)
4 (n-AlGaN)
3 (i-InGaN)
2 (p-MgZnO)
22 (METAL REFLECTIVE LAYER)

99

## Fig.13

25 (ITO)
4 (n-AlGaN)
3 (i-InGaN)
2 (p-MgZnO)
22 (METAL REFLECTIVE LAYER)

98

*Fig.14*

102

13(METAL ELECTRODE)

12(ITO)
52(p-MgZnO)
53(i-ZnO(MgZnO))
54(n-MgZnO)
11(GaN-BUFFER LAYER)
10(SAPPHIRE SUBSTRATE)

*Fig.15*

103

23(METAL ELECTRODE)

24(n-AlGaInN)
54(n-MgZnO)
53(i-ZnO(MgZnO))
52(p-MgZnO)
22(METAL REFLECTIVE LAYER)

*Fig.16*

104

25(ITO)
54(n-MgZnO)
53(i-ZnO(MgZnO))
52(p-MgZnO)
22(METAL REFLECTIVE LAYER)

Fig.17

● ELECTRON
○ HOLE

p-TYPE
CLADDING
LAYER

ACTIVE LAYER
t

n-TYPE CLADDING
LAYER

CONDUCTION
BAND

Ecp

Ecn

DONOR
LEVEL

FORBIDDEN
BAND

Eci

$E_g$ RECOMBINATION

ACCEPTOR
LEVEL

Evi

Evp

Evp

*Fig.18A*

52 (p-MgZnO)
53 (i-ZnO (MgZnO))
54 (n-MgZnO)
11 (GaN-BUFFER LAYER)
10 (SAPPHIRE SUBSTRATE)

*Fig.18B*

22 (METAL REFLECTIVE LAYER)
52 (p-MgZnO)
53 (i-ZnO (MgZnO))
54 (n-MgZnO)
11 (GaN-BUFFER LAYER)
10 (SAPPHIRE SUBSTRATE)

*Fig.18C*

22 (METAL REFLECTIVE LAYER)
52 (p-MgZnO)
53 (i-ZnO (MgZnO))
54 (n-MgZnO)
25 (ITO)

*Fig.18D*

104

22 (METAL REFLECTIVE LAYER)
52 (p-MgZnO)
53 (i-ZnO (MgZnO))
54 (n-MgZnO)
25 (ITO)

*Fig.19A*

PP {
—10(SAPPHIRE SUBSTRATE)

—11(GaN-BUFFER LAYER)

—2(p-MgZnO)

SP {
—53(i-ZnO(MgZnO))

—54(n-MgZnO)

—11(GaN-BUFFER LAYER)

—10(SAPPHIRE SUBSTRATE)

*Fig.19B*

—10(SAPPHIRE SUBSTRATE)

—11(GaN-BUFFER LAYER)

—2(p-MgZnO)

—53(i-ZnO(MgZnO))

—54(n-MgZnO)

—11(GaN-BUFFER LAYER)

—10(SAPPHIRE SUBSTRATE)

*Fig.20A*

200

22 (METAL REFLECTIVE LAYER)
204 (n-TYPE CLADDING LAYER)
203 (ACTIVE LAYER)
202 (p-TYPE CLADDING LAYER)
25 (TRANSPARENT CONDUCTIVE
    MATERIAL LAYER)

VISIBLE LIGHT (BLUE COLOR)

*Fig.20B*

201

201m

22 (METAL REFLECTIVE LAYER)
204 (n-TYPE CLADDING LAYER)
203' (ACTIVE LAYER)
202 (p-TYPE CLADDING LAYER)
25 (TRANSPARENT CONDUCTIVE
    MATERIAL LAYER)

ULTRAVIOLET RADIATION

*Fig.21*

201m

ULTRAVIOLET
RADIATION

204 (n-TYPE CLADDING LAYER)
203' (ACTIVE LAYER)
202 (p-TYPE CLADDING LAYER)

210 (FLUORESCENT
    MATERIAL LAYER)

VISIBLE LIGHT

*Fig.22*

250

201 (LIGHT EMITTING ELEMENT)
212 (LIGHT DIFFUSION PLATE)
209 (TRANSPARENT BASE MEMBER)
210 (FLUORESCENT MATERIAL LAYER)

210a  210a
WHITE LIGHT
211
(TRANSPARENT PROTECTIVE LAYER)

*Fig.23*

201 (LIGHT EMITTING ELEMENT)
209 (TRANSPARENT BASE MEMBER)
210 (FLUORESCENT MATERIAL LAYER)
211 (TRANSPARENT PROTECTIVE LAYER)
212 (LIGHT DIFFUSION PLATE)

*Fig.24*

td   201   251
212
209
210
211

*Fig.25*

252   212
201
209
210
211

*Fig.26A*

201    209

210R    210G    210B    DP

*Fig.26B*

210R    210B    210G

Ⓡ  Ⓑ  Ⓖ  Ⓡ  Ⓑ  Ⓖ

　Ⓖ  Ⓡ  Ⓑ  Ⓖ  Ⓡ  Ⓑ

Ⓡ  Ⓑ  Ⓖ  Ⓡ  Ⓑ  Ⓖ

　Ⓖ  Ⓡ  Ⓑ  Ⓖ  Ⓡ  Ⓑ

*Fig.27*

13(METAL ELECTRODE)    105

22(METAL REFLECTIVE LAYER)

52(p-MgZnO)
53(i-ZnO(MgZnO))
54(n-MgZnO)
8(n-ZnO BUFFER LAYER)
9(GLASS SUBSTRATE)

## Fig.28A

22 (METAL REFLECTIVE LAYER)
52 (p-MgZnO)
53 (i-ZnO (MgZnO))
54 (n-MgZnO)
8 (n-ZnO BUFFER LAYER)
9 (GLASS SUBSTRATE)

## Fig.28B

13 (METAL ELECTRODE)
105
22 (METAL REFLECTIVE LAYER)
52 (p-MgZnO)
53 (i-ZnO (MgZnO))
54 (n-MgZnO)
8 (n-ZnO BUFFER LAYER)
9 (GLASS SUBSTRATE)

## Fig.29

260
13a 22a 13a 22a 13a 22a 13a 22a 71 72 73 75
22 105 22 105 22 105 22 105
13 13 13 13 13 13 13
76
74 174 10

*Fig.30*

*Fig.31*

*Fig.32*

## INTERNATIONAL SEARCH REPORT

| International application No. |
| --- |
| PCT/JP01/10361 |

**A. CLASSIFICATION OF SUBJECT MATTER**
Int.Cl⁷ H01L33/00, H01L21/365

According to International Patent Classification (IPC) or to both national classification and IPC

**B. FIELDS SEARCHED**

Minimum documentation searched (classification system followed by classification symbols)
Int.Cl⁷ H01L33/00, H01L21/34-21/365

Documentation searched other than minimum documentation to the extent that such documents are included in the fields searched
Jitsuyo Shinan Koho 1965-1996 Jitsuyo Shinan Toroku Koho 1996-2002
Kokai Jitsuyo Shinan Koho 1971-2002 Toroku Jitsuyo Shinan Koho 1994-2002

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 00/16411 A1 (Rohm Co., Ltd.), 23 March, 2000 (23.03.2000) (Family: none) Full text; all drawings | 1,2,5,8,12, 13,17-19,24 |
| Y | page 100, lines 9 to 12 | 3,4,6,7 |
| Y | page 32, lines 8 to 15 | 10,11 |
| Y | | 14-16 |
| Y | page 66, lines 19 to 22; page 68, lines 15 to 22; page 80, lines 26 to 28 | 21-23 |
| Y | | 28-35 |
| A | | 9,20,25-27 |
| Y | DE 19921987 A1 (Toyoda Gosei Co., Ltd.), 18 November, 1999 (18.11.1999), & JP 2000-183400 A Full text; all drawings | 14-16 |
| A | JP 7-235505 A (Matsushita Electric Ind. Co., Ltd.), 05 September, 1995 (05.09.1995), (Family: none) | 20 |

☒ Further documents are listed in the continuation of Box C.   ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search 22 February, 2002 (22.02.02) | Date of mailing of the international search report 05 March, 2002 (05.03.02) |
| --- | --- |
| Name and mailing address of the ISA/ Japanese Patent Office | Authorized officer |
| Facsimile No. | Telephone No. |

Form PCT/ISA/210 (second sheet) (July 1992)

**INTERNATIONAL SEARCH REPORT**

International application No.

PCT/JP01/10361

C (Continuation).   DOCUMENTS CONSIDERED TO BE RELEVANT

| Category* | Citation of document, with indication, where appropriate, of the relevant passages | Relevant to claim No. |
|---|---|---|
| A | JP 4-133418 A (Toshiba Corporation), 07 May, 1992 (07.05.1992), (Family: none) | 20 |
| A | JP 9-331105 A (NEC Corporation), 22 December, 1997 (22.12.1997), (Family: none) | 25,26 |
| Y | JP 10-41546 A (Nippon Sanso Corporation), 13 February, 1998 (13.02.1998)   (Family: none) Par. Nos. [0016], [0019], [0034] | 28-35 |
| Y | WO 97/48138 A2 (Philips Electronics N.V.), 18 December, 1997 (18.12.1997), & EP 856202 A        & JP 11-510968 A Full text; all drawings | 28-35 |
| EX | JP 2001-44499 A (Agency of Industrial Science and Technology), 16 February, 2001 (16.02.2001)   (Family: none) Par. No. [0041] | 1,2,5,8,12, 13,17,19,24 |
| EX | JP 2001-44500 A (Agency of Industrial Science and Technology), 16 February, 2001 (16.02.2001)   (Family: none) Par. No. [0041] | 1,2,5,8,12, 13,17,19,21, 22,24 |

Form PCT/ISA/210 (continuation of second sheet) (July 1992)

**EP 1 349 217 A1**

---

<table>
<tr><td><strong>INTERNATIONAL SEARCH REPORT</strong></td><td>International application No.<br>PCT/JP01/10361</td></tr>
</table>

---

**Box I    Observations where certain claims were found unsearchable (Continuation of item 1 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box II    Observations where unity of invention is lacking (Continuation of item 2 of first sheet)**

This International Searching Authority found multiple inventions in this international application, as follows:

The technical feature common to claim 1 and 28 is disclosed in document a listed below, and makes no contribution over the prior art. Consequently, the common technical feature is not a special technical feature within the meaning of PCT Rule 13.2, second sentence. As a result the inventions of claims 1, 28 do not comply with the requirement of unity of invention.
The technical feature common to claims 2, 3, 4, 5, 6-7, 8-16, 17, 18, 19-27 dependent on claim 1 is also disclosed in document a, and makes no contribution over the prior art. Consequently, the common technical feature is not a special technical feature within the meaning of PCT Rule 13.2, second sentence. The inventions of claims 2, 3, 4, 5, 6-7, 8-16, 17, 18, 19-27 do not comply with the requirement of unity of invention.

Document a:  WO 00/16411 A1 (Rohm Co., Ltd.) 2000.03.23

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**    ☐    The additional search fees were accompanied by the applicant's protest.

☒    No protest accompanied the payment of additional search fees.

Form PCT/ISA/210 (continuation of first sheet (1)) (July 1992)

37